# EUROPEAN PATENT APPLICATION

(11) **EP 4 607 578 A1**
(43) Date of publication of application: **27.08.2025**
(21) Application number: 24212961.7
(22) Date of filing: 14.11.2024
(51) Int. Cl.: H01L 21/768, H01L 23/522, H01L 23/528

(54) **INTEGRATED CIRCUIT DEVICE AND METHOD OF MANUFACTURING THE SAME**

(30) Priority: 21.02.2024 KR 20240025306; 16.04.2024 KR 20240050914
(71) Applicant: Samsung Electronics Co., Ltd., Suwon-si, Gyeonggi-do 16677 (KR)
(72) Inventor: PARK, Jongsoon, 16677 Suwon-si, Gyeonggi-do (KR); RA, Hyonwook, 16677 Suwon-si, Gyeonggi-do (KR); BAI, Keunhee, 16677 Suwon-si, Gyeonggi-do (KR); LEE, Jinwook, 16677 Suwon-si, Gyeonggi-do (KR); CHOI, Hobum, 16677 Suwon-si, Gyeonggi-do (KR)
(74) Representative: Kuhnen & Wacker Patent- und Rechtsanwaltsbüro PartG mbB

(57) **Abstract**

An integrated circuit device includes a first lower metal wiring layer (130A), an upper insulating film (140) and a first upper metal wiring layer (180LA) on the first lower metal wiring layer (130A), and a first conductive contact plug (180CA) passing through the upper insulating film (140) in a vertical direction (Z) to contact the first lower and first upper metal wiring layers (130a, 180LA), and the first conductive contact plug (180CA) has a tetragonal planar shape. Each of first contact sidewalls (180VS) of the first conductive contact plug (180CA) in a first lateral direction (X) extends from a corresponding one of upper line sidewalls (180LS) of the first upper metal wiring layer (180LA) to the lower metal wiring layer (130A) in the vertical direction (Z), and at least one of a pair of second contact sidewalls (180TS) of the first conductive contact plug (180CA) in a second lateral direction (Y) extends in a direction inclined with respect to the vertical direction (Z) from a bottom surface of the upper metal wiring layer (180LA) toward the lower metal wiring layer (130A).

## Description

### BACKGROUND

The inventive concepts relate to an integrated circuit (IC) device, and more particularly, to an IC device including a metal wiring layer and a method of manufacturing the IC device.

The downscaling of IC devices has rapidly progressed due to the development of electronics technology. Thus, metal wiring layers included in the IC devices are being reduced in terms of linewidth and pitch. Accordingly, it is necessary to improve electrical reliability of metal wiring structures.

### SUMMARY

Some example embodiments of the inventive concepts provide integrated circuit (IC) devices having a structure capable of improving electrical reliability of metal wiring structures by improving the contact resistance of metal wiring structures connected to each other while reducing the possibility of short circuits between adjacent metal wiring structures.

Some example embodiments of the inventive concepts provide methods of manufacturing an IC device, which may improve electrical reliability of metal wiring structures by improving the contact resistance of metal wiring structures connected to each other while reducing the possibility of short circuits between adjacent metal wiring structures.

According to an example embodiment of the inventive concepts, an IC device includes a lower insulating film on a substrate, a lower metal wiring layer passing through the lower insulating film and extending lengthwise in a first lateral direction, an upper insulating film on the lower insulating film and the lower metal wiring layer, an upper metal wiring layer extending lengthwise in a second lateral direction on the upper insulating film, wherein the second lateral direction is perpendicular to the first lateral direction, and a conductive contact plug passing through the upper insulating film in a vertical direction, the conductive contact plug contacting each of the lower metal wiring layer and the upper metal wiring layer, wherein the conductive contact plug has a tetragonal shape in a view from above, the conductive contact plug includes a pair of first contact sidewalls, which are opposite to each other in the first lateral direction, and a pair of second contact sidewalls, which are opposite to each other in the second lateral direction, each of the pair of first contact sidewalls extends in the vertical direction from an upper line sidewall of the upper metal wiring layer to the lower metal wiring layer, and at least one of the pair of second contact sidewalls extends in a direction inclined with respect to the vertical direction from a bottom surface of the upper metal wiring layer toward the lower metal wiring layer.

According to an example embodiment of the inventive concepts, an IC device includes a lower insulating film on a substrate, a first lower metal wiring layer and a second lower metal wiring layer each passing through the lower insulating film and extending lengthwise in a first lateral direction, the first lower metal wiring layer and the second lower metal wiring layer being apart from each other in a second lateral direction, the second lateral direction being perpendicular to the first lateral direction, an upper insulating film on each of the lower insulating film, the first lower metal wiring layer, and the second lower metal wiring layer, a first upper metal wiring layer and a second upper metal wiring layer on the upper insulating film, the first upper metal wiring layer and the second upper metal wiring layer overlapping the first lower metal wiring layer and the second lower metal wiring layer in a vertical direction and extending lengthwise in the second lateral direction, and the first upper metal wiring layer and the second upper metal wiring layer being apart from each other in the first lateral direction, a first conductive contact plug passing through the upper insulating film in the vertical direction, the first conductive contact plug contacting each of the first lower metal wiring layer and the first upper metal wiring layer, and a second conductive contact plug passing through the upper insulating film in the vertical direction, the second conductive contact plug contacting each of the second lower metal wiring layer and the second upper metal wiring layer, wherein each of the first conductive contact plug and the second conductive contact plug has a tetragonal shape in a view from above, each of the first conductive contact plug and the second conductive contact plug includes a pair of first contact sidewalls and a pair of second contact sidewalls, the pair of first contact sidewalls being opposite to each other in the first lateral direction, the pair of second contact sidewalls being opposite to each other in the second lateral direction, in each of the first conductive contact plug and the second conductive contact plug, each of the pair of first contact sidewalls extends in the vertical direction from a corresponding one of a pair of upper line sidewalls of a corresponding one of the first and second upper metal wiring layers extending in the second lateral direction to a corresponding one of the first and second lower metal wiring layers, and, in each of the first conductive contact plug and the second conductive contact plug, at least one of the pair of second contact sidewalls extends in a direction inclined with respect to the vertical direction from a bottom surface of a corresponding one of the first and second upper metal wiring layers toward the corresponding one of the first and second lower metal wiring layers.

According to an example embodiment of the inventive concepts, an IC device includes a lower structure on a substrate, a lower insulating film on the lower structure, a lower metal wiring layer passing through the lower insulating film and extending lengthwise in a first lateral direction, an upper insulating film on the lower insulating film and the lower metal wiring layer, the upper insulating film defining a line space and a via space connected to the line space, the via space extending from the line space to the lower metal wiring layer in a vertical direction, an upper metal wiring layer filling the line space, the upper metal wiring layer extending lengthwise in a second lateral direction, the second lateral direction being perpendicular to the first lateral direction, and a conductive contact plug filling the via space and contacting each of the lower metal wiring layer and the upper metal wiring layer, wherein the upper metal wiring layer includes a portion extending from a top surface of the upper insulating film to a top surface of the conductive contact plug in the vertical direction, the conductive contact plug has a tetragonal shape in a view from above, the conductive contact plug includes a pair of first contact sidewalls and a pair of second contact sidewalls, the pair of first contact sidewalls being opposite to each other in the first lateral direction and facing the upper insulating film, the pair of second contact sidewalls being opposite to each other in the second lateral direction and facing the upper insulating film, each of the pair of first contact sidewalls extends in the vertical direction from a corresponding one upper line sidewall adjacent thereto, from among a pair of upper line sidewalls included in the upper metal wiring layer, to the lower metal wiring layer, the pair of upper line sidewalls being opposite to each other in the first lateral direction, and at least one of the pair of second contact sidewalls extends in a direction inclined with respect to the vertical direction from a bottom surface of the upper metal wiring layer toward the lower metal wiring layer.

According to an example embodiment of the inventive concepts, a method of manufacturing an IC device includes forming a lower insulating film and a lower metal wiring layer on a substrate, the lower metal wiring layer passing through the lower insulating film and extending lengthwise in a first lateral direction on the substrate. An upper metal wiring structure is formed on the lower insulating film and the lower metal wiring layer. The upper metal wiring structure includes an upper metal wiring layer and a conductive contact plug, the upper metal wiring layer extending lengthwise in a second lateral direction on the lower insulating film and the lower metal wiring layer, the conductive contact plug being integrally connected to the upper metal wiring layer and contacting the lower metal wiring layer, wherein the second lateral direction is perpendicular to the first lateral direction. The conductive contact plug has a tetragonal shape in a view from above, the conductive contact plug includes a pair of first contact sidewalls and a pair of second contact sidewalls, the pair of first contact sidewalls being opposite to each other in the first lateral direction, and the pair of second contact sidewalls being opposite to each other in the second lateral direction, each of the pair of first contact sidewalls extends in a vertical direction from a corresponding one of a pair of upper line sidewalls of the upper metal wiring layer to the lower metal wiring layer, the pair of upper line sidewalls of the upper metal wiring layer being opposite to each other in the first lateral direction, and at least one of the pair of second contact sidewalls extends in a direction inclined with respect to the vertical direction from a bottom surface of the upper metal wiring layer toward the lower metal wiring layer.

According to an example embodiment of the inventive concepts, a method of manufacturing an IC device includes forming a lower insulating film, a first lower metal wiring layer, and a second lower metal wiring layer on a substrate, the first lower metal wiring layer and the second lower metal wiring layer passing through the lower insulating film and extending lengthwise in a first lateral direction on the substrate, and the first lower metal wiring layer and the second lower metal wiring layer being apart from each other in a second lateral direction, the second lateral direction being perpendicular to the first lateral direction, forming an upper insulating film on the lower insulating film, the first lower metal wiring layer, and the second lower metal wiring layer; and forming a plurality of upper metal wiring structures in the upper insulating film and on the lower insulating film, the first lower metal wiring layer, and the second lower metal wiring layer. The plurality of upper metal wiring structures include a first upper metal wiring layer and a second upper metal wiring layer overlapping the first lower metal wiring layer and the second lower metal wiring layer in a vertical direction, the first upper metal wiring layer and the second upper metal wiring layer extending lengthwise in the second lateral direction and being apart from each other in the first lateral direction, a first conductive contact plug contacting each of the first lower metal wiring layer and the first upper metal wiring layer; and a second conductive contact plug contacting each of the second lower metal wiring layer and the second upper metal wiring layer. Each of the first conductive contact plug and the second conductive contact plug has a tetragonal shape in a view from above, each of the first conductive contact plug and the second conductive contact plug includes a pair of first contact sidewalls and a pair of second contact sidewalls, the pair of first contact sidewalls being opposite to each other in the first lateral direction and facing the upper insulating film, the pair of second contact sidewalls being opposite to each other in the second lateral direction and facing the upper insulating film. In each of the first conductive contact plug and the second conductive contact plug, each of the pair of first contact sidewalls extends in the vertical direction, and at least one of the pair of second contact sidewalls extends in a direction inclined with respect to the vertical direction.

According to an example embodiment of the inventive concepts, a method of manufacturing an IC device includes forming a lower insulating film, a first lower metal wiring layer, and a second lower metal wiring layer on a substrate, the first lower metal wiring layer and the second lower metal wiring layer passing through the lower insulating film and extending lengthwise in a first lateral direction on the substrate, and the first lower metal wiring layer and the second lower metal wiring layer being apart from each other in a second lateral direction that is perpendicular to the first lateral direction, forming a plurality of upper metal wiring structures on the lower insulating film, the first lower metal wiring layer, and the second lower metal wiring layer. The forming of the plurality of upper metal wiring structures includes forming an upper insulating film including a line space and a via space on the lower insulating film and the lower metal wiring layer, the line space being apart from each of the lower insulating film and the lower metal wiring layer in the vertical direction, the via space being connected to the line space and exposing the lower metal wiring layer, and forming a metal-containing conductive layer to fill the via space and the line space. The forming of the upper insulating film including the line space and the via space includes forming an upper insulating film having a planarized top surface on the lower insulating film and the lower metal wiring layer, forming, on the upper insulating film having the planarized top surface, a first hard mask pattern including a first opening, the first opening exposing a top surface of the upper insulating film, forming a planarized hard mask layer to cover the upper insulating film and the first hard mask pattern, forming, on the planarized hard mask layer, an inorganic hard mask pattern having a second opening, the second opening overlapping the first opening in the vertical direction, and forming a second hard mask pattern having an extended second opening from the inorganic hard mask pattern having the second opening by selectively increasing only a first width of the second opening in the first lateral direction, from among the first width and a second width of the second opening in the second lateral direction, and wherein the formation of the second hard mask pattern having the extended second opening includes performing an ion beam etch process in the first lateral direction while varying an ion beam incidence direction within a range between 50° and 90° with respect to a straight line parallel to a main surface of the substrate and performing an ion beam etch process in the second lateral direction while ion beams are incident in a direction perpendicular to the main surface of the substrate.

### BRIEF DESCRIPTION OF THE DRAWINGS

Example embodiments will be more clearly understood from the following detailed description taken in conjunction with the accompanying drawings in which:
FIG. 1A is a plan layout diagram of an integrated circuit (IC) device according to an example embodiment;
FIG. 1B is a cross-sectional view taken along line X1 - X1' of FIG. 1A;
FIG. 1C is a cross-sectional view taken along line Y1 - Y1' of FIG. 1A;
FIG. 2 is a partial perspective view of some components of the IC device shown in FIGS. 1A, 1B, and 1C;
FIG. 3A is a plan layout diagram of an IC device according to an example embodiment;
FIG. 3B is a cross-sectional view taken along line X1 - X1' of FIG. 3A;
FIG. 3C is a cross-sectional view taken along line Y1 - Y1' of FIG. 3A;
FIG. 4 is a partial perspective view of some components of the IC device shown in FIGS. 3A, 3B, and 3C;
FIG. 5A is a plan layout diagram of an IC device according to an example embodiment;
FIG. 5B is a cross-sectional view taken along lines Y1 - Y1' and Y2 - Y2' of FIG. 5A;
FIGS. 6A and 6B are cross-sectional views of an IC device according to an example embodiment;
FIG. 7 is a plan layout diagram of an IC device according to an example embodiment;
FIG. 8 is a cross-sectional view taken along line X1 - X1' of FIG. 7;
FIG. 9 is a cross-sectional view taken along line Y1 - Y1' of FIG. 7;
FIG. 10 is a cross-sectional view of an IC device according to an example embodiment;
FIGS. 11A, 12A, 13A, 14A, 15A, 16A, 17A, 18A, 19A, and 20A are plan views of process sequences of methods of manufacturing IC devices, according to an example embodiment, FIGS. 11B, 12B, 13B, 14B, 15B, 16B, 17B, 18B, 19B, and 20B are cross-sectional views taken along lines X1-X1' of FIGS. 11A, 12A, 13A, 14A, 15A, 16A, 17A, 18A, 19A, and 20A, respectively, and FIGS. 15C, 16C, 17C, 18C, 19C, and 20C are cross-sectional views taken along lines Y1-Y1' of FIGS. 15A, 16A, 17A, 18A, 19A, and 20A, respectively;
FIG. 21 is a plan view illustrating a method of manufacturing an IC device, according to an example embodiment; and
FIG. 22 is a plan view illustrating a method of manufacturing an IC device, according to an example embodiment.

### DETAILED DESCRIPTION

Hereinafter, some example embodiments will be described in detail with reference to the accompanying drawings. The same reference numerals are used to denote the same elements in the drawings, and repeated descriptions thereof are omitted.

Terms such as "first" and "second" are used herein merely to describe a variety of constituent elements, but the constituent elements are not limited by the terms. Such terms are used only for the purpose of distinguishing one constituent element from another constituent element. For example, without departing from the right scope of various example embodiments described below, a first constituent element may be referred to as a second constituent element, and vice versa. When constituent elements are separately referred to as a first constituent element and a second constituent element in the following detailed description and claims, they are not the same constituent element. While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

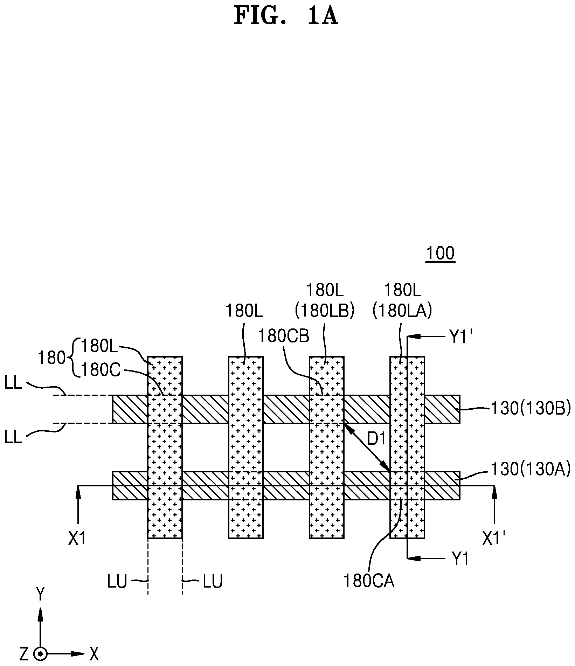

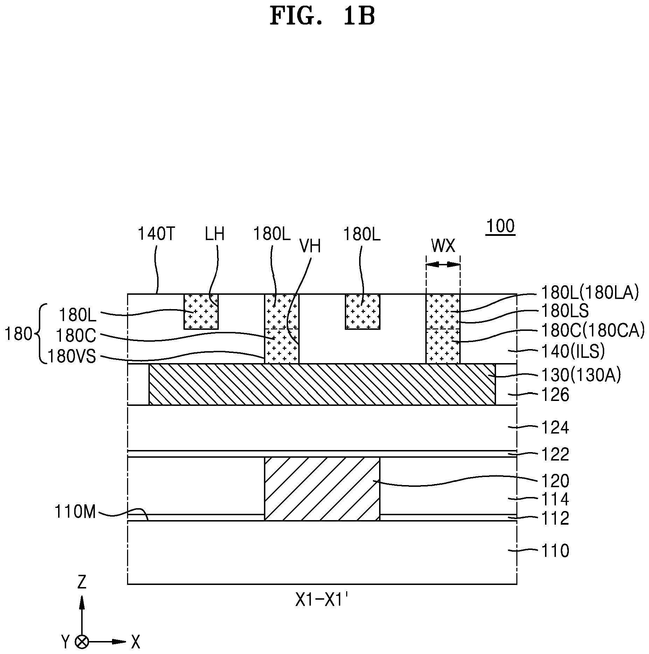

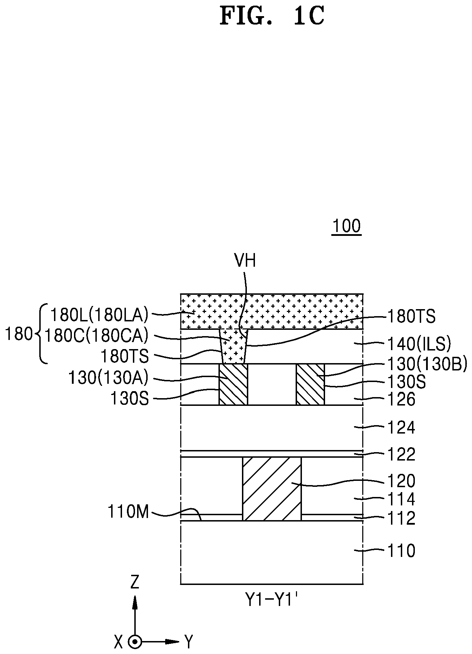

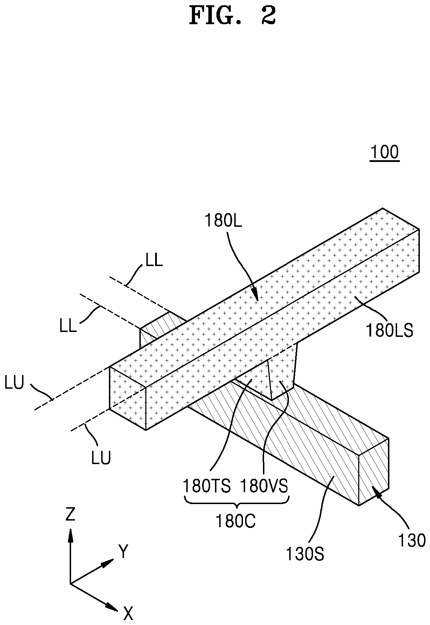

FIG. 1A is a plan layout diagram of an IC device 100 according to an example embodiment. FIG. 1B is a cross-sectional view taken along line X1 - X1' of FIG. 1A. FIG. 1C is a cross-sectional view taken along line Y1 - Y1' of FIG. 1A. FIG. 2 is a partial perspective view of some components of the IC device 100.

Referring to FIGS. 1A, 1B, 1C, and 2, the IC device 100 may include a lower structure on a substrate 110. The lower structure may include a first lower etch stop film 112, a first interlayer insulating film 114, a second lower etch stop film 122, and a second interlayer insulating film 124, which are sequentially on a main surface 110M of the substrate 110 in a vertical direction (Z direction), and a conductive structure 120 passing through the first interlayer insulating film 114 and the first lower etch stop film 112 in the vertical direction (Z direction).

The substrate 110 may include a semiconductor, such as silicon (Si) or germanium (Ge), or a compound semiconductor element, such as silicon germanium (SiGe), silicon carbide (SiC), gallium arsenide (GaAs), indium arsenide (InAs), or indium phosphide (InP). The substrate 110 may include a conductive region (not shown). The conductive region may include a doped well, a doped structure, or a conductive layer. The substrate 110 may include circuit elements (not shown), such as a gate structure, an impurity region, and a contact plug.

Each of the first interlayer insulating film 114 and the second interlayer insulating film 124 may include a silicon oxide film. For example, each of the first interlayer insulating film 114 and the second interlayer insulating film 124 may include a silicon-oxide-based material, such as plasma enhanced oxide (PEOX), tetraethyl orthosilicate (TEOS), boro TEOS (BTEOS), phosphorous TEOS (PTEOS), boro phospho TESO (BPTEOS), boro silicate glass (BSG), phospho silicate glass (PSG), and boro PSG (BPSG). In other example embodiments, each of the first interlayer insulating film 114 and the second interlayer insulating film 124 may have a low-k dielectric film (e.g., a SiOC film or a SiCOH film) having a low dielectric constant K of about 2.2 to about 3.0.

Each of the first lower etch stop film 112 and the second lower etch stop film 122 may include a material having a different etch selectivity from a constituent material of each of the first interlayer insulating film 114 and the second interlayer insulating film 124. For example, each of the first lower etch stop film 112 and the second lower etch stop film 122 may include a silicon nitride film, a carbon-doped silicon nitride film, or a carbon-doped silicon oxynitride film. In some example embodiments, each of the first lower etch stop film 112 and the second lower etch stop film 122 may include an insulating metal oxide film, an insulating metal nitride film, or a combination thereof. For example, the first lower etch stop film 112 and the second lower etch stop film 122 may include an aluminum oxide film (AlO film), an aluminum nitride film (AlN film), or a combination thereof.

In some example embodiments, the conductive structure 120 may be a wiring layer including a metal film and a conductive barrier film surrounding the metal film. In the conductive structure 120, the metal film may include copper (Cu), tungsten (W), molybdenum (Mo), ruthenium (Ru), cobalt (Co), aluminum (Al), or a combination thereof, and the conductive barrier film may include a titanium nitride (TiN) film, a tantalum nitride (TaN) film, a cobalt (Co) film, or a combination thereof, without being limited thereto. In some example embodiments, the conductive structure 120 may be electrically connected to the conductive region formed in the substrate 110. In other example embodiments, the conductive structure 120 may be connected to a source/drain region (not shown) or a gate electrode (not shown) of a transistor formed in the substrate 110.

A lower insulating film 126 may be on the second interlayer insulating film 124, and a plurality of lower metal wiring layers 130 may pass through the lower insulating film 126 in the vertical direction (Z direction). The plurality of lower metal wiring layers 130 may extend lengthwise in a first lateral direction (X direction) and be apart from each other in a second lateral direction (Y direction), which is perpendicular to the first lateral direction (X direction). The plurality of lower metal wiring layers 130 may extend parallel to each other.

An upper insulating film 140 may be on the lower insulating film 126 and the plurality of lower metal wiring layers 130. As used herein, the upper insulating film 140 may be referred to as an upper insulating structure ILS. Constituent materials of the lower insulating film 126 and the upper insulating film 140 are the same as or substantially similar to those of the first interlayer insulating film 114 and the second interlayer insulating film 124, which have been described above.

A plurality of upper metal wiring structures 180 may be on the upper insulating film 140. Each of the plurality of upper metal wiring structures 180 may include an upper metal wiring layer 180L and a conductive contact plug 180C integrally connected to the upper metal wiring layer 180L.

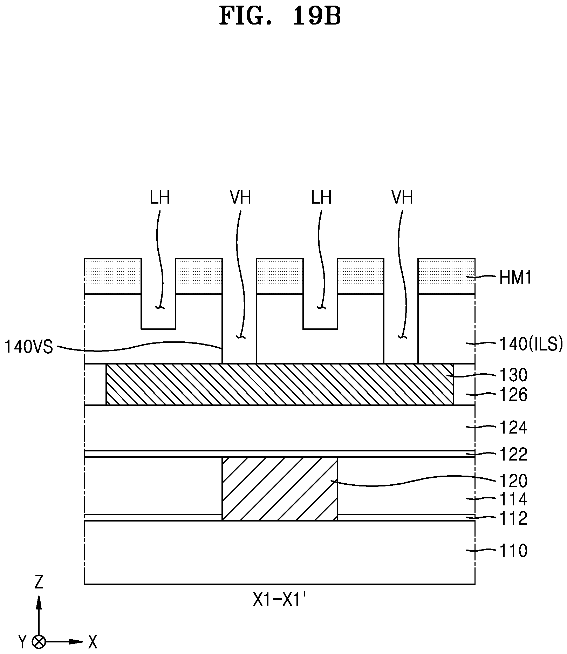

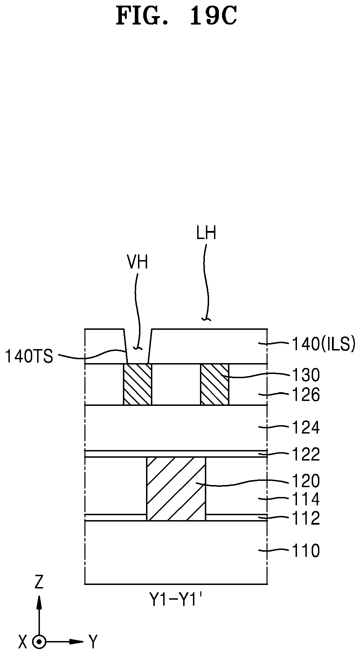

The upper insulating film 140 may have a shape defining a line space LH and a via space VH connected to the line space LH. The via space VH may extend from the line space LH to the lower metal wiring layer 130 in the vertical direction (Z direction). The line space LH may extend lengthwise in the second lateral direction (Y direction). Respective sectional shapes of the line space LH and the via space VH defined by the upper insulating film 140 in each of the first lateral direction (X direction) and the second lateral direction (Y direction) are illustrated more clearly in FIGS. 19B and 19C. In each of the plurality of upper metal wiring structures 180, the upper metal wiring layer 180L may fill the line space LH defined by the upper insulating film 140, and the conductive contact plug 180C may fill the via space VH defined by the upper insulating film 140. The upper metal wiring layer 180L may include a portion extending from a top surface 140T of the upper insulating film 140 to a top surface of the conductive contact plug 180C in the vertical direction (Z direction).

In each of the plurality of upper metal wiring structures 180, the upper metal wiring layer 180L may overlap at least one lower metal wiring layer 130 selected from the plurality of lower metal wiring layers 130 in a vertical direction. In the plurality of upper metal wiring structures 180, each of a plurality of upper metal wiring layers 180L may extend lengthwise in the second lateral direction (Y direction) and be apart from each other in the first lateral direction (X direction). The plurality of upper metal wiring layers 180L may extend parallel to each other. Each of the plurality of upper metal wiring layers 180L may be on the upper insulating film 140 and overlap a plurality of lower metal wiring layers 130 in the vertical direction (Z direction).

The conductive contact plug 180C may be at an intersection between a selected one of the plurality of lower metal wiring layers 130 and a selected one of the plurality of upper metal wiring structures 180. In FIG. 1A, a plurality of conductive contact plugs 180C included in the plurality of upper metal wiring structures 180 are illustrated with dashed lines. As shown in FIG. 1A, each of the plurality of conductive contact plugs 180C may have a tetragonal shape in a view from above (on an X-Y plane).

Each of the plurality of lower metal wiring layers 130 and the plurality of upper metal wiring layers 180L may include a metal film, a conductive metal nitride film, or a combination thereof. In some example embodiments, at least one of the plurality of lower metal wiring layers 130 or the plurality of upper metal wiring layers 180L may include a metal plug and a conductive barrier film surrounding a sidewall and a bottom surface of the metal plug. The metal plug may include copper (Cu), tungsten (W), molybdenum (Mo), ruthenium (Ru), cobalt (Co), aluminum (Al), or a combination thereof. For example, the metal plug may include copper (Cu). The conductive barrier film may include a TiN film, a TaN film, a Co film, or a combination thereof. For example, when the metal plug includes Cu, the conductive barrier film may have a multilayered structure including a TaN film and a Co film, without being limited thereto.

Each of the plurality of conductive contact plugs 180C included in the plurality of upper metal wiring structures 180 may pass through the upper insulating film 140 in the vertical direction (Z direction) and contact a selected one of the plurality of lower metal wiring layers 130. Each of the plurality of conductive contact plugs 180C may extend in the vertical direction (Z direction) between a selected one of the plurality of upper metal wiring layers 180L and a selected one of the plurality of lower metal wiring layers 130 and contact each of the selected upper metal wiring layer 180L and the selected lower metal wiring layer 130.

For example, as shown in FIG. 1A, the plurality of conductive contact plugs 180C may include a first conductive contact plug 180CA and a second conductive contact plug 180CB. As shown in FIGS. 1A, 1B, and 1C, the first conductive contact plug 180CA may extend in the vertical direction (Z direction) between a first lower metal wiring layer 130A, which is a selected one of the plurality of lower metal wiring layers 130, and a first upper metal wiring layer 180LA, which is a selected one of the plurality of upper metal wiring layers 180L, and contact each of the first lower metal wiring layer 130A and the first upper metal wiring layer 180LA. The second conductive contact plug 180CB may extend in the vertical direction (Z direction) between a second lower metal wiring layer 130B, which is a selected one of the plurality of lower metal wiring layers 130, and a second upper metal wiring layer 180LB, which is a selected one of the plurality of upper metal wiring layers 180L, and contact each of the second lower metal wiring layer 130B and the second upper metal wiring layer 180LB.

As shown in FIGS. 1B, 1C, and 2, each of the plurality of conductive contact plugs 180C may include a pair of first contact sidewalls 180VS and a pair of second contact sidewalls 180TS. The pair of first contact sidewalls 180VS may be opposite to each other in the first lateral direction (X direction) and each face the upper insulating film 140. The pair of second contact sidewalls 180TS may be opposite to each other in the second lateral direction (Y direction) and each face the upper insulating film 140

Each of the plurality of upper metal wiring layers 180L may include a pair of upper line sidewalls (refer to 180LS in FIGS. 1B and 2), which are opposite to each other in the first lateral direction (X direction). The pair of upper line sidewalls 180LS may extend in the vertical direction (Z direction), which is that is perpendicular to the main surface 110M of the substrate 110, on a plane (Y-Z plane).

In each of the plurality of conductive contact plugs 180C, each of the pair of first contact sidewalls 180VS may extend in the vertical direction (Z direction), which is perpendicular to the main surface 110M of the substrate 110, on the plane (Y-Z plane). Each of the pair of first contact sidewalls 180VS may extend in the vertical direction (Z direction) from one upper line sidewall 180LS adjacent thereto, from among the pair of upper line sidewalls (refer to 180LS in FIGS. 1B and 2) included in a corresponding one of the plurality of upper metal wiring layers 180L, to a corresponding one of the plurality of lower metal wiring layers 130. As used herein, it will be understood that when a constituent element is referred to as corresponding to another constituent element, it can be connected to the other constituent element.

In each of the plurality of conductive contact plugs 180C, at least one of the pair of second contact sidewalls 180TS may extend in a direction inclined with respect to the vertical direction (Z direction) from a bottom surface of a corresponding one of the plurality of upper metal wiring layers 180L toward a corresponding one of the plurality of lower metal wiring layers 130. For example, as shown in FIGS. 1C and 2, each of the pair of second contact sidewalls 180TS may have an inclined surface that gets close to a vertical central axis of the conductive contact plug 180C toward (e.g., as it gets close to) a corresponding one of the lower metal wiring layers 130.

As shown in FIG. 1B, in the plurality of upper metal wiring structures 180, the upper metal wiring layer 180L and the conductive contact plug 180C, which are connected to each other, may have a same width WX in the first lateral direction (X direction), and the width WX of each of the upper metal wiring layer 180L and the conductive contact plug 180C in the first lateral direction (X direction) may be constant in the vertical direction (Z direction). In some example embodiments, a width of each of the plurality of conductive contact plugs 180C in the second lateral direction (Y direction) may gradually reduce toward the lower metal wiring layer 130 or the substrate 110.

In a view from above (on an X-Y plane), the pair of first contact sidewalls 180VS of the conductive contact plug 180C may extend along extension lines of a pair of first straight lines (e.g., a pair of first dashed lines LU in FIGS. 1A and 2), along which the pair of upper line sidewalls 180LS of the upper metal wiring layer 180L corresponding thereto pass.

Each of the plurality of lower metal wiring layers 130 may include a pair of lower line sidewalls (refer to 130S in FIGS. 1C and 2), which are opposite to each other in the second lateral direction (Y direction). In a view from above (on an X-Y plane), of the pair of second contact sidewalls 180TS of the conductive contact plug 180C, portions closest to the upper metal wiring layer 180L may extend along extension lines of a pair of second straight lines (e.g., a pair of second dashed lines LL in FIGS. 1A and 2), along which the pair of lower line sidewalls 130S of the lower metal wiring layer 130 corresponding thereto pass.

In some example embodiments, in a view from above (on an X-Y plane), a planar shape of the conductive contact plug 180C may be the same as a planar shape of a region where the lower metal wiring layer 130 corresponding thereto overlaps the upper metal wiring layer 180L corresponding thereto in the vertical direction (Z direction). For example, as shown in FIG. 1A, a planar shape of the first conductive contact plug 180CA may be the same as a planar shape of a region where the first lower metal wiring layer 130A overlaps the first upper metal wiring layer 180LA in the vertical direction (Z direction). In addition, a planar shape of the second conductive contact plug 180CB may be the same as a planar shape of a region where the second lower metal wiring layer 130B overlaps the second upper metal wiring layer 180LB in the vertical direction (Z direction).

In a view from above (on an X-Y plane), the IC device 100 described with reference to FIGS. 1A, 1B, 1C, and 2 may include the conductive contact plug 180C, which extends in the vertical direction (Z direction) between the lower metal wiring layer 130 and the upper metal wiring layer 180L to connect the lower metal wiring layer 130 to the upper metal wiring layer 180L in a region where the lower metal wiring layer 130 intersects the upper metal wiring layer 180L, and the conductive contact plug 180C may have the same planar shape (e.g., a tetragonal planar shape) as the planar shape of a region where the lower metal wiring layer 130 overlaps the upper metal wiring layer 180L in the vertical direction (Z direction). Accordingly, a planar size of the conductive contact plug 180C configured to connect the lower metal wiring layer 130 to the upper metal wiring layer 180L may be increased or maximized as much as possible without undesired area loss within a limited area to reduce or minimize contact resistance. Furthermore, by increasing a smallest separation distance between adjacent ones of the plurality of conductive contact plugs 180C (e.g., a smallest separation distance D1 between the first conductive contact plug 180CA and the second conductive contact plug 180CB in FIG. 1A), a sufficient insulation distance between adjacent ones of the plurality of conductive contact plugs 180C may be ensured, and thus, the occurrence of an undesired short between adjacent ones of the plurality of conductive contact plugs 180C may be reduced or prevented. Therefore, reliability of electrical connection between the lower metal wiring layer 130 and the upper metal wiring layer 180L through the conductive contact plug 180C may improve, and reliability of the IC device 100 may improve.

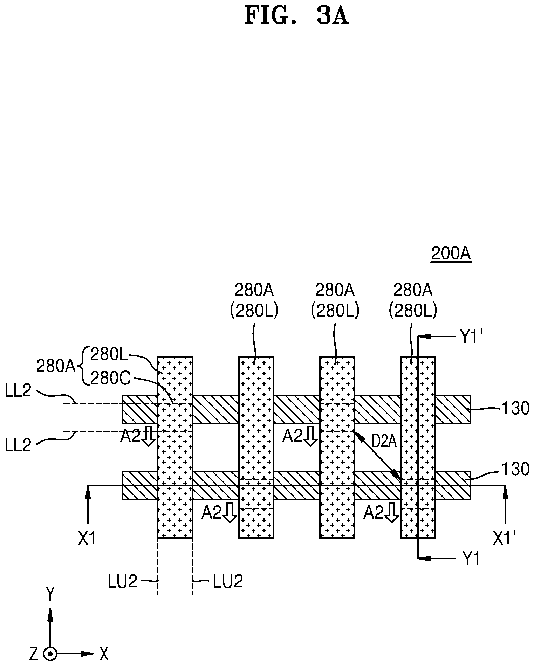

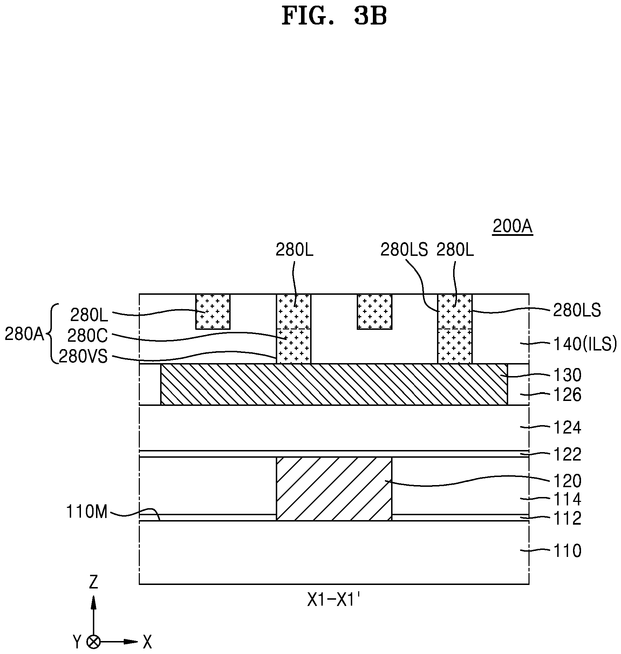

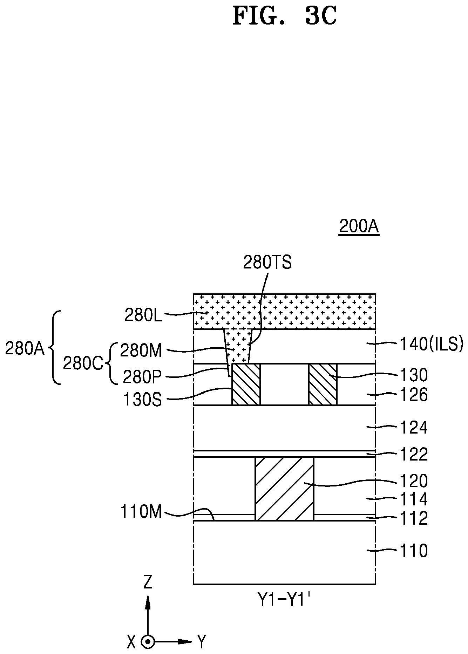

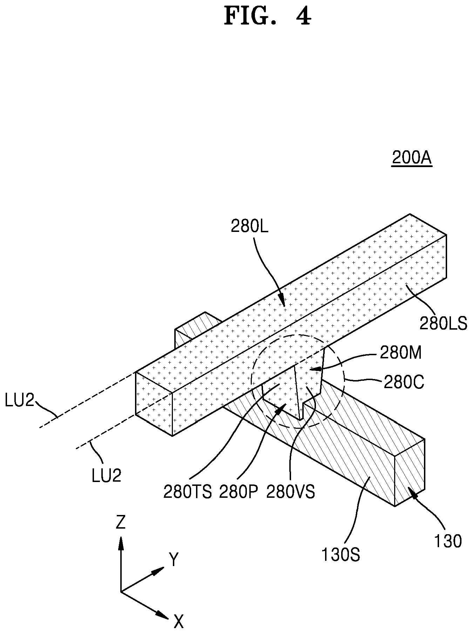

FIG. 3A is a plan layout diagram of an IC device 200A according to an example embodiment. FIG. 3B is a cross-sectional view taken along line X1 - X1' of FIG. 3A. FIG. 3C is a cross-sectional view taken along line Y1 - Y1' of FIG. 3A. FIG. 4 is a partial perspective view of some components of the IC device 200A. In FIGS. 3A, 3B, 3C, and 4, the same reference numerals are used to denote the same elements as in FIGS. 1A, 1B, 1C, and 2, and detailed descriptions thereof are omitted.

Referring to FIGS. 3A, 3B, 3C, and 4, the IC device 200A may have the same or substantially similar configuration as the IC device 100 described with reference to FIGS. 1A, 1B, 1C, and 2. However, the IC device 200A may include a plurality of upper metal wiring structures 280A. Each of the plurality of upper metal wiring structures 280A may include an upper metal wiring layer 280L and a conductive contact plug 280C integrally connected to the upper metal wiring layer 280L. The conductive contact plug 280C may include a main contact portion 280M covering a top surface of the lower metal wiring layer 130 and a protruding contact portion 280P covering a sidewall of the lower metal wiring layer 130. The protruding contact portion 280P may be between the lower metal wiring layer 130 and the lower insulating film 126. That is, the conductive contact plug 280C may cover the top surface and the sidewall of the lower metal wiring layer 130 corresponding thereto.

Each of a plurality of conductive contact plugs 280C may include a pair of first contact sidewalls 280VS and a pair of second contact sidewalls 280TS. The pair of first contact sidewalls 280VS may be opposite to each other in the first lateral direction (X direction) and face the upper insulating film 140. The pair of second contact sidewalls 280TS may be opposite to each other in the second lateral direction (Y direction) and face the upper insulating film 140.

In each of the plurality of conductive contact plugs 280C, each of the pair of first contact sidewalls 280VS may extend in the vertical direction (Z direction) on a plane (Y-Z plane) that is perpendicular to a main surface 110M of a substrate 110. Each of the pair of first contact sidewalls 280VS may extend in the vertical direction (Z direction) from one upper line sidewall 280LS adjacent thereto, from among a pair of upper line sidewalls (refer to 280LS in FIGS. 3B and 4) included in a corresponding one of a plurality of upper metal wiring layers 280L, to a corresponding one of a plurality of lower metal wiring layers 130.

In each of the plurality of conductive contact plugs 280C, one of the pair of second contact sidewalls 280TS may extend in a direction inclined with respect to the vertical direction (Z direction) from a bottom surface of a corresponding one of the plurality of upper metal wiring layers 280L toward the top surface of a corresponding one of the plurality of lower metal wiring layers 130. From among the pair of second contact sidewalls 280TS, another second contact sidewall 280TS may extend in a direction inclined with respect to the vertical direction (Z direction) from the bottom surface of a corresponding one of the plurality of upper metal wiring layers 280L toward the sidewall of a corresponding one of the plurality of lower metal wiring layers 130. For example, as shown in FIGS. 3C and 4, each of the pair of second contact sidewalls 280TS may have an inclined surface that gets close to a vertical central axis of the conductive contact plug 280C toward (e.g., as it gets close to) a corresponding one of the lower metal wiring layers 130.

In a view from above (on an X-Y plane), the pair of first contact sidewalls 280VS of the conductive contact plug 280C may extend along extension lines of a pair of first straight lines (e.g., a pair of first dashed lines LU2 in FIGS. 3A and 4), along which the pair of upper line sidewalls 280LS of the upper metal wiring layer 280L extend. In a view from above (on an X-Y plane), the pair of second contact sidewalls 280TS of the conductive contact plug 280C may extend along extension lines of a pair of second straight lines (e.g., a pair of second dashed lines LL2 in FIG. 3A), which extend in the first lateral direction (X direction), at a position shifted by a distance greater than 0 from the pair of lower line sidewalls 130S of the lower metal wiring layer 130 corresponding thereto in a direction (e.g., a direction indicated by arrow A2 in FIG. 3A) selected from the second lateral direction (Y direction) and a direction opposite to the second lateral direction (Y direction).

Detailed configurations of the plurality of upper metal wiring layers 280L and the plurality of conductive contact plugs 280C included in the plurality of upper metal wiring structures 280A are and the same as or substantially similar to those of the plurality of upper metal wiring layers 180L and the plurality of conductive contact plugs 180C, which have been described with reference to FIGS. 1A, 1B, 1C, and 2, respectively.

In a view from above (on an X-Y plane), the IC device 200A described with reference to FIGS. 3A, 3B, 3C, and 4 may include the conductive contact plug 280C, which extends in the vertical direction (Z direction) between the lower metal wiring layer 130 and the upper metal wiring layer 280L to connect the lower metal wiring layer 130 to the upper metal wiring layer 280L in a region where the lower metal wiring layer 130 intersects the upper metal wiring layer 280L, and the conductive contact plug 280C may have a tetragonal planar shape. Accordingly, a planar size of the conductive contact plug 280C configured to connect the lower metal wiring layer 130 to the upper metal wiring layer 280L may be increased or maximized as much as possible without undesired area loss within a limited area to reduce or minimize contact resistance. Furthermore, by increasing a smallest separation distance between adjacent ones of the plurality of conductive contact plugs 280C (e.g., a smallest separation distance D2A between two adjacent conductive contact plugs 280C in FIG. 3A), a sufficient insulation distance between two adjacent ones of the plurality of conductive contact plugs 280C may be ensured, and thus, the occurrence of an undesired short between adjacent ones of the plurality of conductive contact plugs 280C may be reduced or prevented. Therefore, reliability of electrical connection between the lower metal wiring layer 130 and the upper metal wiring layer 280L through the conductive contact plug 280C may improve, and reliability of the IC device 200A may improve.

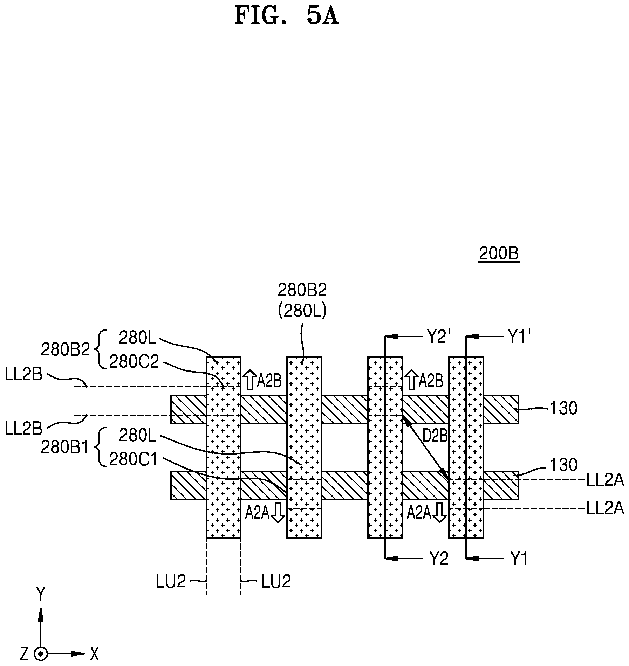

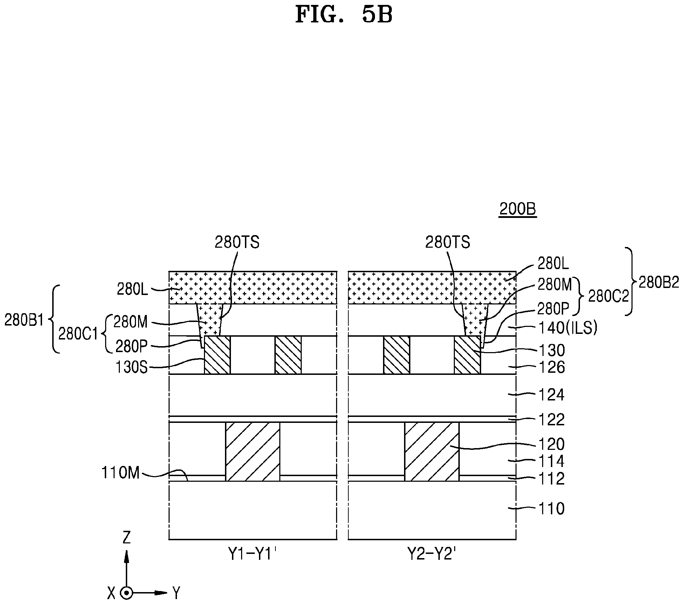

FIG. 5A is a plan layout diagram of an IC device 200B according to an example embodiment. FIG. 5B is a cross-sectional view taken along lines Y1 - Y1' and Y2 - Y2' of FIG. 5A. In FIGS. 5A and 5B, the same reference numerals are used to denote the same elements as in FIGS. 1A to 4, and detailed descriptions thereof are omitted.

Referring to FIGS. 5A and 5B, the IC device 200B may have the same or substantially similar configuration as the IC device 100 described with reference to FIGS. 1A, 1B, 1C, and 2. However, the IC device 200B may include a plurality of first upper metal wiring structures 280B 1 and a plurality of second upper metal wiring structures 280B2.

Each of the plurality of first upper metal wiring structures 280B 1 may include an upper metal wiring layer 280L and a first conductive contact plug 280C1 integrally connected to the upper metal wiring layer 280L. Each of the plurality of second upper metal wiring structures 280B2 may include an upper metal wiring layer 280L and a second conductive contact plug 280C2 integrally connected to the upper metal wiring layer 280L. Each of the first conductive contact plug 280C1 and the second conductive contact plug 280C2 may include a main contact portion 280M covering a top surface of a lower metal wiring layer 130 and a protruding contact portion 280P covering a sidewall of the lower metal wiring layer 130. The protruding contact portion 280P may be between the lower metal wiring layer 130 and the lower insulating film 126. That is, each of the first conductive contact plug 280C1 and the second conductive contact plug 280C2 may cover the top surface and the sidewall of the lower metal wiring layer 130 corresponding thereto.

Similar to the plurality of conductive contact plugs 280C described with reference to FIGS. 3A, 3B, 3C, and 4, each of a plurality of first conductive contact plugs 280C1 and a plurality of second conductive contact plugs 280C2 may have a pair of first contact sidewalls (corresponding to the pair of first contact sidewalls 280VS shown in FIGS. 3B and 4), which are opposite to each other in a first lateral direction (X direction) and face the upper insulating film 140, and each of the pair of first contact sidewalls 280VS may extend in a vertical direction (Z direction) on a plane (Y-Z plane) that is perpendicular to the main surface 110M of the substrate 110. Each of the pair of first contact sidewalls may extend in the vertical direction (Z direction) from one upper line sidewall adjacent thereto, from among a pair of upper line sidewalls (corresponding to the pair of upper line sidewalls 280LS shown in FIGS. 3B and 4) included in a corresponding one of a plurality of upper metal wiring layers 280L, to a corresponding one of the plurality of lower metal wiring layers 130.

As shown in FIG. 5B, each of the plurality of first conductive contact plugs 280C1 and the plurality of second conductive contact plugs 280C2 may include a pair of second contact sidewalls 280TS, which are opposite to each other in the second lateral direction (Y direction) and face the upper insulating film 140. In each of the plurality of first conductive contact plugs 280C1 and the plurality of second conductive contact plugs 280C2, detailed configurations of the pair of second contact sidewalls 280TS are the same as or substantially similar to those of the pair of second contact sidewalls 280TS included in the conductive contact plug 280C described with reference to FIGS. 3A and 3C.

In a view from above (on an X-Y plane), the pair of first contact sidewalls of each of the plurality of first conductive contact plugs 280C1 and the plurality of second conductive contact plugs 280C2 may extend along extension lines of a pair of first straight lines (e.g., a pair of first dashed lines LU2 in FIG. 5A), along which the pair of upper line sidewalls 280LS of the upper metal wiring layer 280L corresponding thereto pass.

In a view from above (on an X-Y plane), the pair of second contact sidewalls 280TS of each of the plurality of first conductive contact plugs 280C1 may extend along extension lines of a pair of second straight lines (e.g., a pair of second dashed lines LL2A in FIG. 5A), which extend in the first lateral direction (X direction), at a position shifted by a distance greater than 0 from the pair of lower line sidewalls 130S of the lower metal wiring layer 130 corresponding thereto in a direction (e.g., a direction indicated by arrow A2A in FIG. 5A) opposite to the second lateral direction (Y direction).

In a view from above (on an X-Y plane), the pair of second contact sidewalls 280TS of each of the plurality of second conductive contact plugs 280C2 may extend along extension lines of a pair of third straight lines (e.g., a pair of third dashed lines LL2B in FIG. 5A), which extend in the first lateral direction (X direction), at a position shifted by a distance greater than 0 from the pair of lower line sidewalls 130S of the lower metal wiring layer 130 corresponding thereto in the second lateral direction (Y direction) (e.g., a direction indicated by arrow A2B in FIG. 5A).

Detailed configurations of the plurality of upper metal wiring layers 280L included in the plurality of first upper metal wiring structures 280B 1 and the plurality of second upper metal wiring structures 280B2, the plurality of first conductive contact plugs 280C1, and the plurality of second conductive contact plugs 280C2 are respectively and the same as or substantially similar to those of the plurality of upper metal wiring layers 180L) and the plurality of conductive contact plugs 180C, which have been described above with reference to FIGS. 1A, 1B, 1C, and 2.

In a view from above (on an X-Y plane), the IC device 200B described with reference to FIGS. 5A and 5B may include the first conductive contact plug 280C1 and the second conductive contact plug 280C2, each of which extends in the vertical direction (Z direction) between a selected one of the plurality of lower metal wiring layers 130 and a selected one of the plurality of upper metal wiring layers 280L to connect the selected lower metal wiring layer 130 to the selected upper metal wiring layer 280L in a region where the plurality of lower metal wiring layers 130 intersect the plurality of upper metal wiring layers 280L, and each of the first conductive contact plug 280C1 and the second conductive contact plug 280C2 may have a tetragonal planar shape. Accordingly, a planar size of the first conductive contact plug 280C1 or the second conductive contact plug 280C2 configured to connect the lower metal wiring layer 130 to the upper metal wiring layer 280L may be increased or maximized as much as possible without undesired area loss within a limited area to reduce or minimize contact resistance. Furthermore, by increasing a smallest separation distance between adjacent ones of a plurality of first conductive contact plugs 280C1 and a plurality of second conductive contact plugs 280C2 (e.g., a smallest separation distance D2B between the first conductive contact plug 280C1 and the second conductive contact plug 280C2 in FIG. 5A), a sufficient insulation distance therebetween may be ensured, and thus, the occurrence of an undesired short between adjacent ones of the plurality of first conductive contact plugs 280C1 and the plurality of second conductive contact plugs 280C2 may be reduced or prevented. Therefore, reliability of electrical connection between the lower metal wiring layer 130 and the upper metal wiring layer 280L through the first conductive contact plug 280C1 and/or the second conductive contact plug 280C2 may improve, and reliability of the IC device 200B may improve.

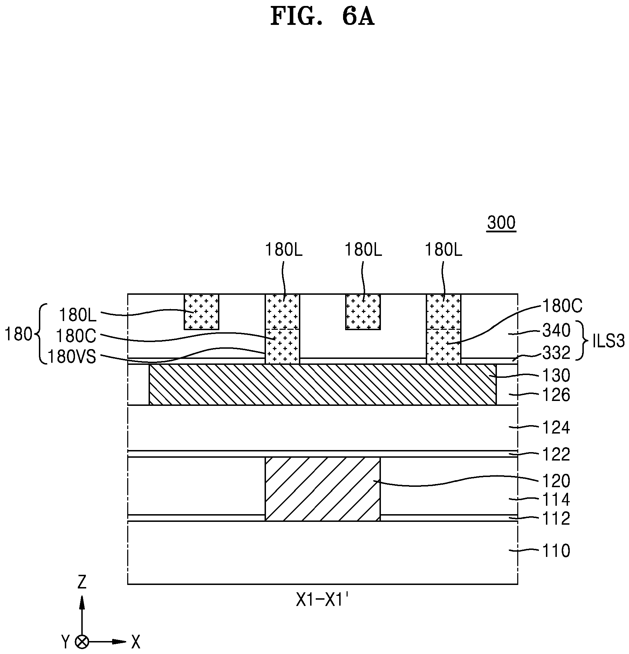

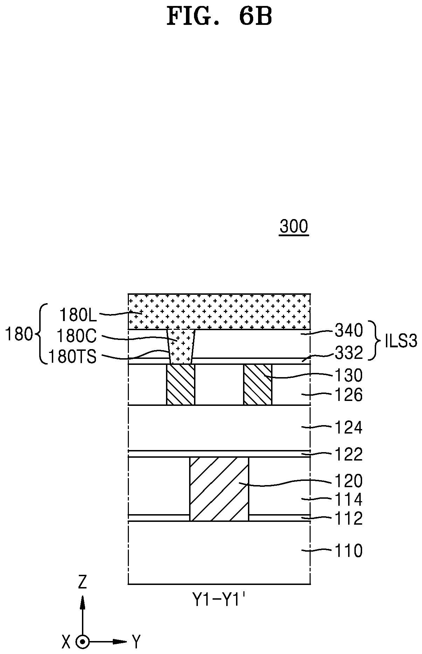

FIGS. 6A and 6B are cross-sectional views of an IC device 300 according to an example embodiment. FIG. 6A illustrates components in a portion corresponding to a cross-section taken along line X1 - X1' of FIG. 1A in the IC device 300. FIG. 6B illustrates components in a portion corresponding to a cross-section taken along line Y1 - Y1' of FIG. 1A in the IC device 300. In FIGS. 6A and 6B, the same reference numerals are used to denote the same elements as in FIGS. 1A, 1B, 1C, and 2, and detailed descriptions thereof are omitted.

Referring to FIGS. 6A and 6B, the IC device 300 may have the same or substantially similar configuration as the IC device 100 described with reference to FIGS. 1A, 1B, 1C, and 2. However, the IC device 300 may include an upper insulating structure ILS3 including an etch stop film 332 and an upper insulating film 340.

In some example embodiments, the etch stop film 332 may have a multilayered structure in which a first insulating film containing metal, a second insulating film free from metal, and a third insulating film containing metal are sequentially stacked. Each of the first insulating film and the third insulating film may include an aluminum oxide film, an aluminum nitride film, or a combination thereof. For example, each of the first insulating film and the third insulating film may include an aluminum oxide film, an aluminum nitride film, or a combination thereof. The second insulating film may include a silicon oxide film, a SiOC film, or a combination thereof. Thicknesses of the first insulating film and the third insulating film may be different from each other in a vertical direction (Z direction). In some example embodiments, in the vertical direction (Z direction), respective thicknesses of the first insulating film, the second insulating film, and the third insulating film may be different from each other. For example, a thickness of the third insulating film may be greater than a thickness of the first insulating film. However, the inventive concepts are not limited thereto, and each of the first insulating film, the second insulating film, and the third insulating film may be formed to various thicknesses as needed. In other example embodiments, the etch stop film 332 may have a single film structure including a metal-containing insulating film. For example, the etch stop film 332 may include an aluminum oxide film, an aluminum nitride film, or a combination thereof. In the upper insulating structure ILS3, a constituent material of the upper insulating film 340 may be the same as a constituent material of the upper insulating film 140, which has been described with reference to FIGS. 1B and 1C.

Each of the plurality of conductive contact plugs 180C included in a plurality of upper metal wiring structures 180 may pass through the upper insulating film 340 and the etch stop film 332 in the vertical direction (Z direction) and contact the lower metal wiring layer 130 corresponding thereto.

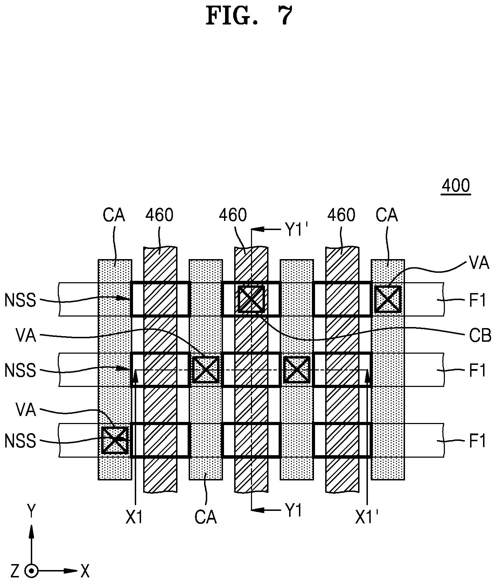

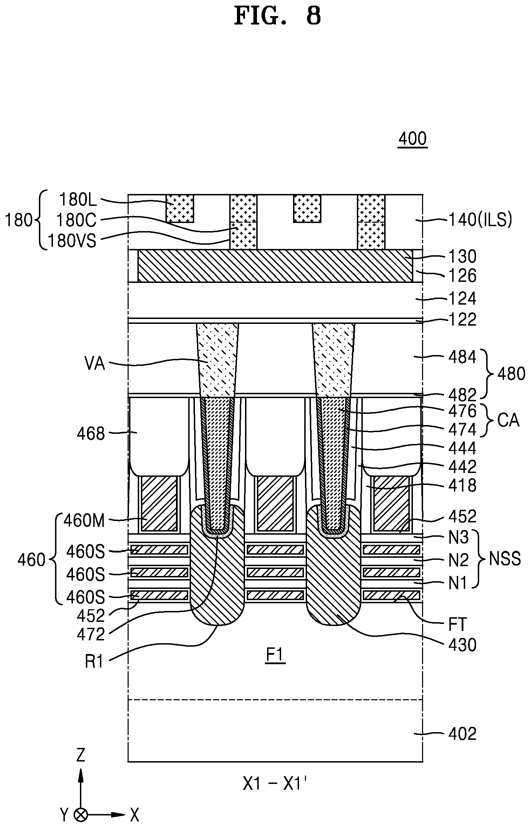

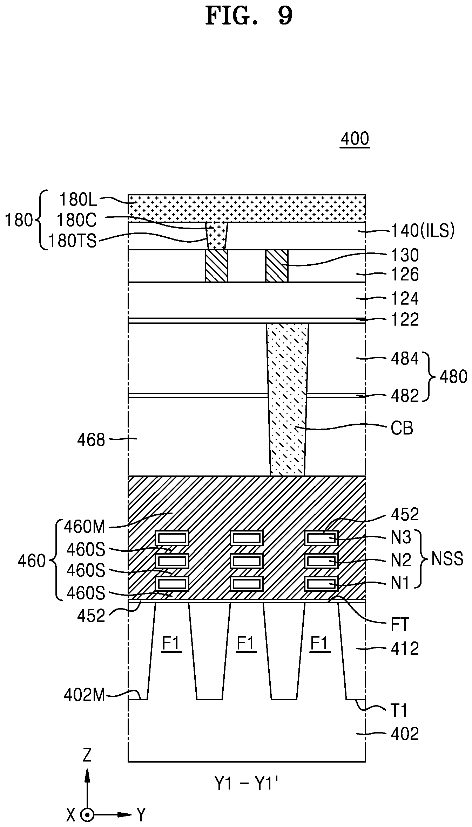

FIG. 7 is a plan layout diagram of an IC device 400 according to an example embodiment. FIG. 8 is a cross-sectional view taken along line X1 - X1' of FIG. 7. FIG. 9 is a cross-sectional view taken along line Y1 - Y1' of FIG. 7. The IC device 400 including a field-effect transistor (FET) having a gate-all-around structure, which includes an active region of a nanowire or nanosheet type and a gate surrounding the active region, is described with reference to FIGS. 7 to 9. In FIGS. 7 to 9, the same reference numerals are used to denote the same elements as in FIGS. 1A, 1B, 1C, and 2, and detailed descriptions thereof are omitted.

Referring to FIGS. 7 to 9, the IC device 400 may include a plurality of fin-type active regions F 1 and a plurality of nanosheet stacks NSS. The plurality of fin-type active regions F 1 may protrude from a substrate 402 and extend lengthwise in a first lateral direction (X direction). The plurality of nanosheet stacks NSS may be apart upward from the plurality of fin-type active regions F1 in a vertical direction (Z direction) and face fin top surfaces FT of the plurality of fin-type active regions F1. As used herein, the term "nanosheet" refers to a conductive structure having a cross-section that is substantially perpendicular to a direction in which current flows. The nanosheet may be interpreted as including a nanowire.

A trench T1 defining the plurality of fin-type active regions F1 may be formed in the substrate 402. The trench T1 may be filled by a device isolation film 412. The substrate 402 may include a semiconductor element, such as silicon (Si) or germanium (Ge), or a compound semiconductor, such as silicon germanium (SiGe), silicon carbide (SiC), gallium arsenide (GaAs), indium arsenide (InAs), indium gallium arsenide (InGaAs), or indium phosphide (InP). The substrate 402 may include a conductive region, for example, a doped well or a doped structure. The device isolation film 412 may include an oxide film, a nitride film, or a combination thereof.

A plurality of gate lines 460 may be on the plurality of fin-type active regions F1. Each of the plurality of gate lines 460 may extend lengthwise in a second lateral direction (Y direction) that intersects the first lateral direction (X direction).

A plurality of nanosheet stacks NSS may be on the fin top surfaces FT of the plurality of fin-type active regions F1, respectively, in regions where the plurality of fin-type active regions F1 intersect the plurality of gate lines 460. Each of the plurality of nanosheet stacks NSS may include at least one nanosheet facing the fin top surface FT of the fin-type active region F1 at a position apart from the fin top surface FT of the fin-type active region F1 in the vertical direction (Z direction).

In some example embodiments, each of the plurality of nanosheet stacks NSS may include a first nanosheet N1, a second nanosheet N2, and a third nanosheet N3, which overlap each other in the vertical direction (Z direction) on the fin-type active region F1. Each of the plurality of gate lines 460 may surround the first nanosheet N1, the second nanosheet N2, and the third nanosheet N3, which overlap each other in the vertical direction (Z direction) and are included in the nanosheet stack NSS.

Each of the plurality of gate lines 460 may include a main gate portion 460M and a plurality of sub-gate portions 460S. The main gate portion 460M may extend lengthwise in the second lateral direction (Y direction), while covering a top surface of the nanosheet stack NSS. The plurality of sub-gate portions 460S may be integrally connected to the main gate portion 460M and located between the first nanosheet N1, the second nanosheet N2, and the third nanosheet N3 and between the first nanosheet N1 and the fin-type active region F1, respectively. In the vertical direction (Z direction), a thickness of each of the plurality of sub-gate portions 460S may be less than a thickness of the main gate portion 460M.

A plurality of recesses R1 may be formed in the fin-type active region F1. A lowermost surface of each of the plurality of recesses R1 may be at a lower vertical level than the fin top surface FT of the fin-type active region F1. The plurality of source/drain regions 430 may be inside the plurality of recesses R1. Each of the plurality of source/drain regions 430 may be adjacent to at least one gate line 460 selected from the plurality of gate lines 460. Each of the plurality of source/drain regions 430 may be in contact with the first nanosheet N1, the second nanosheet N2, and the third nanosheet N3, which are included in the nanosheet stack NSS adjacent thereto.

Each of the plurality of gate lines 460 may include metal, metal nitride, metal carbide, or a combination thereof. The metal may be selected from titanium (Ti), tungsten (W), ruthenium (Ru), niobium (Nb), molybdenum (Mo), hafnium (Hf), nickel (Ni), cobalt (Co), platinum (Pt), ytterbium (Yb), terbium (Tb), dysprosium (Dy), erbium (Er), and palladium (Pd). The metal nitride may be selected from TiN and TaN. The metal carbide may include titanium aluminum carbide (TiAlC). However, a constituent material of the plurality of gate lines 460 is not limited to the examples described above. Each of the plurality of gate lines 460 may further include a gap-fill metal film. The gap-fill metal film may include a tungsten (W) film and an aluminum (Al) film. In some example embodiments, each of the plurality of gate lines 460 may include a TiN film, a stack structure of TiAlC/TiN/W, a stack structure of TiN/TaN/TiAlC/TiN/W, or a stack structure of TiN/TaN/TiN/TiAlC/TiN/W, without being limited thereto.

A gate dielectric film 452 may be between the nanosheet stack NSS and the gate line 460. In some example embodiments, the gate dielectric film 452 may include a stack structure of an interface dielectric film and a high-k dielectric film. The interface dielectric film may include a low-k dielectric material film having a dielectric constant of about 9 or lower, for example, a silicon oxide film, a silicon oxynitride film, or a combination thereof. In some example embodiments, the interface dielectric film may be omitted. The high-k dielectric film may include a material having a higher dielectric constant than a silicon oxide film. For example, the high-k dielectric film may have a dielectric constant of about 10 to about 25. The high-k dielectric film may include hafnium oxide, without being limited thereto.

Both sidewalls of the gate line 460 may be covered by insulating spacers 418. The insulating spacers 418 may cover both sidewalls of the main gate portion 460M on a top surface of each of the plurality of nanosheet stacks NSS. The insulating spacers 418 may be apart from the gate line 460 with the gate dielectric film 452 therebetween. The insulating spacers 418 may include silicon nitride, silicon oxide, silicon carbonitride (SiCN), silicon boronitride (SiBN), silicon oxynitride (SiON), silicon oxycarbonitride (SiOCN), silicon boron carbonitride (SiBCN), silicon oxycarbide (SiOC), or a combination thereof.

A top surface of each of the gate dielectric film 452, the gate line 460, and the insulating spacers 418 may be covered by a capping insulating pattern 468. The capping insulating pattern 468 may contact a top surface of each of the gate dielectric film 452, the gate line 460, and the insulating spacers 418. The capping insulating pattern 468 may include a silicon nitride film.

Both sidewalls of each of the plurality of sub-gate portions 460S may be apart from the source/drain region 430 with the gate dielectric film 452 therebetween. The gate dielectric film 452 may be between the sub-gate portion 460S included in the gate line 460 and each of the first nanosheet N1, the second nanosheet N2, and the third nanosheet N3 and between the sub-gate portion 460S included in the gate line 460 and the source/drain region 430.

A plurality of nanosheet transistors may be formed in portions where the plurality of fin-type active regions F1 intersect the plurality of gate lines 460 on the substrate 402. Each of the first nanosheet N1, the second nanosheet N2, and the third nanosheet N3 included in the nanosheet stack NSS may have a channel region. In some example embodiments, each of the first nanosheet N1, the second nanosheet N2, and the third nanosheet N3 included in the nanosheet stack NSS may include a silicon (Si) layer, a silicon germanium (SiGe) layer, or a combination thereof.

A meal silicide film 472 may be formed on a top surface of each of the plurality of source/drain regions 430. The metal silicide film 472 may include metal, which includes Ti, W, Ru, Nb, Mo, Hf, Ni, Co, Pt, Yb, Tb, Dy, Er, or Pd. For example, the metal silicide film 472 may include titanium silicide, without being limited thereto.

An insulating liner 442 and an inter-gate dielectric film 444 may be sequentially on the plurality of source/drain regions 430 and a plurality of metal silicide films 472. In some example embodiments, the insulating liner 442 may include silicon nitride (SiN), SiCN, SiBN, SiON, SiOCN, SiBCN, or a combination thereof, and the inter-gate dielectric film 444 may include a silicon oxide film, without being limited thereto.

A plurality of source/drain contacts CA may be on the plurality of source/drain regions 430. Each of the plurality of source/drain contacts CA may pass through the inter-gate dielectric film 444 and the insulating liner 442 in the vertical direction (Z direction) and contact the metal silicide film 472. Each of the plurality of source/drain contacts CA may be electrically connectable to the source/drain region 430 through the metal silicide film 472. Each of the plurality of source/drain contacts CA may be apart from the main gate portion 460M with the insulating spacers 418 therebetween in the first lateral direction (X direction).

Each of the plurality of source/drain contacts CA may include a conductive barrier film 474 and a contact plug 476, which are sequentially stacked on the metal silicide film 472. The conductive barrier film 474 may surround and contact a bottom surface and a sidewall of the contact plug 476. In some example embodiments, the conductive barrier film 474 may include metal or metal nitride. For example, the conductive barrier film 474 may include titanium (Ti), tantalum (Ta), tungsten (W), titanium nitride (TiN), tantalum nitride (TaN), tungsten nitride (WN), tungsten carbonitride (WCN), titanium silicon nitride (TiSiN), tantalum silicon nitride (TaSiN), tungsten silicon nitride (WSiN), or a combination thereof. The contact plug 476 may include metal selected from molybdenum (Mo), copper (Cu), tungsten (W), cobalt (Co), ruthenium (Ru), manganese (Mn), titanium (Ti), tantalum (Ta), aluminum (Al), and a combination thereof.

A lower insulating structure 480 may be on a top surface of each of the plurality of source/drain contacts CA and a plurality of capping insulating patterns 468. The lower insulating structure 480 may include a lower etch stop film 482 and a first interlayer insulating film 484, which are sequentially stacked on the top surface of each of the plurality of capping insulating patterns 468. The lower etch stop film 482 may include silicon carbide (SiC), silicon nitride (SiN), nitrogen (N)-doped silicon carbide (SiC:N), silicon oxycarbide (SiOC), aluminum nitride (AlN), aluminum oxynitride (AlON), aluminum oxide (AlO), aluminum oxycarbide (AlOC), or a combination thereof. A constituent material of the first interlayer insulating film 484 may be the same as or substantially similar to that of the first interlayer insulating film 114 described with reference to FIG. 2.

As shown in FIG. 8, a plurality of source/drain via contacts VA may be on the plurality of source/drain contacts CA, respectively. Each of the plurality of source/drain via contacts VA may pass through the lower insulating structure 480 and contact the source/drain contact CA. Each of the plurality of source/drain regions 430 may be electrically connected to the source/drain via contact VA through the metal silicide film 472 and the source/drain contact CA.

As shown in FIG. 9, a gate contact CB may be on the gate line 460. The gate contact CB may pass through the lower insulating structure 480 and the capping insulating pattern 468 in the vertical direction (Z direction) and be connected to the gate line 460.

Each of the plurality of source/drain via contacts VA and the gate contact CB may include a contact plug, which includes molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof, but a constituent material of the contact plug is not limited thereto. In some example embodiments, each of the plurality of source/drain via contacts VA and the gate contact CB may further include a conductive barrier pattern surrounding a portion of the contact plug. The conductive barrier pattern included in each of the plurality of source/drain via contacts VA and the gate contact CB may include metal or metal nitride. For example, the conductive barrier pattern may include Ti, Ta, W, TiN, TaN, WN, WCN, TiSiN, TaSiN, WSiN, or a combination thereof, without being limited thereto.

A second lower etch stop film 122 and a second interlayer insulating film 124 may be sequentially stacked on each of the lower insulating structure 480, the source/drain via contact VA, and the gate contact CB. A lower insulating film 126, a plurality of lower metal wiring layers 130, an upper insulating film 140, and a plurality of upper metal wiring structures 180 may be on the second interlayer insulating film 124. Each of the plurality of upper metal wiring structures 180 may include an upper metal wiring layer 180L and a conductive contact plug 180C integrally connected to the upper metal wiring layer 180L.

Each of the plurality of conductive contact plugs 180C may include a pair of first contact sidewalls 180VS and a pair of second contact sidewalls 180TS. The pair of first contact sidewalls 180VS may be opposite to each other in the first lateral direction (X direction) and face the upper insulating film 140. The pair of second contact sidewalls 180TS may be opposite to each other in the second lateral direction (Y direction) and face the upper insulating film 140. Each of the pair of first contact sidewalls 180VS may extend in the vertical direction (Z direction), which is that is perpendicular to a main surface 110M of the substrate 110, on a plane (Y-Z plane). From among the pair of second contact sidewalls 180TS, at least one second contact sidewall 180TS may extend in a direction inclined with respect to the vertical direction (Z direction) from a bottom surface of a corresponding one of a plurality of upper metal wiring layers 180L toward a corresponding one of the plurality of lower metal wiring layers 130. Detailed configurations and effects of the plurality of upper metal wiring structures 180 are the same as those described with reference to FIGS. 1A, 1B, 1C, and 2.

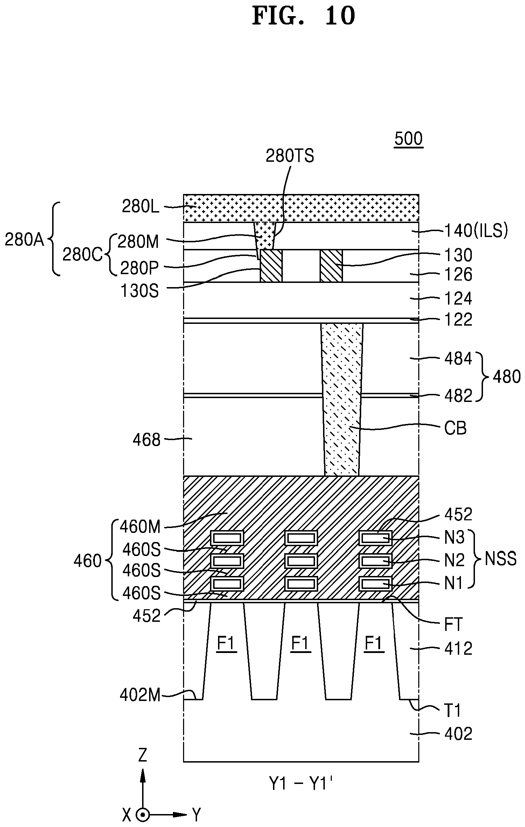

FIG. 10 is a cross-sectional view of an IC device 500 according to an example embodiment. FIG. 10 illustrates components in a portion corresponding to a cross-section taken along line Y1 - Y1' of FIG. 1A in the IC device 500. In FIG. 10, the same reference numerals are used to denote the same elements as in FIGS. 1A to 4, and detailed descriptions thereof are omitted.

Referring to FIG. 10, the IC device 500 may have the same or substantially similar configuration as the IC device 400 described with reference to FIGS. 6 to 9. However, the IC device 500 may include a plurality of upper metal wiring structures 280A. Each of the plurality of upper metal wiring structures 280A may include an upper metal wiring layer 280L and a conductive contact plug 280C integrally connected to the upper metal wiring layer 280L. The conductive contact plug 280C may include a main contact portion 280M covering a top surface of a lower metal wiring layer 130 and a protruding contact portion 280P covering a sidewall of the lower metal wiring layer 130. The protruding contact portion 280P may be between the lower metal wiring layer 130 and the lower insulating film 126. That is, the conductive contact plug 280C may cover the top surface and sidewall of the lower metal wiring layer 130 corresponding thereto. Detailed configurations and effects of the plurality of upper metal wiring structures 280A are the same as those described with reference to FIGS. 3A, 3B, 3C, and 4.

In the IC devices 400, 500 described with reference to FIGS. 7 to 10, similar to the IC device 100 described with reference to FIGS. 3A, 3B, 3C, and 4, a planar size of the conductive contact plug 180C or 280C configured to connect the lower metal wiring layer 130 to the upper metal wiring layer 180L or 280L may be increased or maximized as much as possible without undesired area loss within a limited area to reduce or minimize contact resistance. Furthermore, by increasing a smallest separation distance between adjacent ones of the plurality of conductive contact plugs 180C and 280C, a sufficient insulation distance between adjacent ones of the plurality of conductive contact plugs 180C and 280C may be ensured, and thus, the occurrence of an undesired short between adjacent ones of the plurality of conductive contact plugs 180C and 280C may be reduced or prevented. Therefore, reliability of electrical connection between the lower metal wiring layer 130 and the upper metal wiring layer 180L or 280L through the conductive contact plug 180C or 280C may improve, and reliability of the IC device 200A may improve.

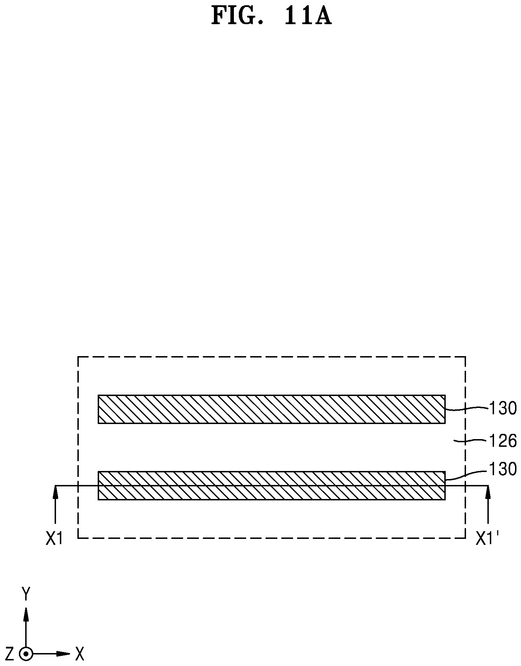

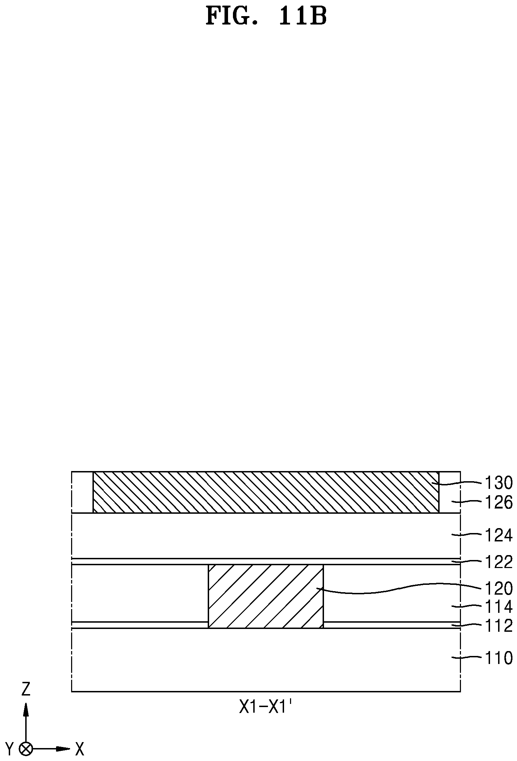

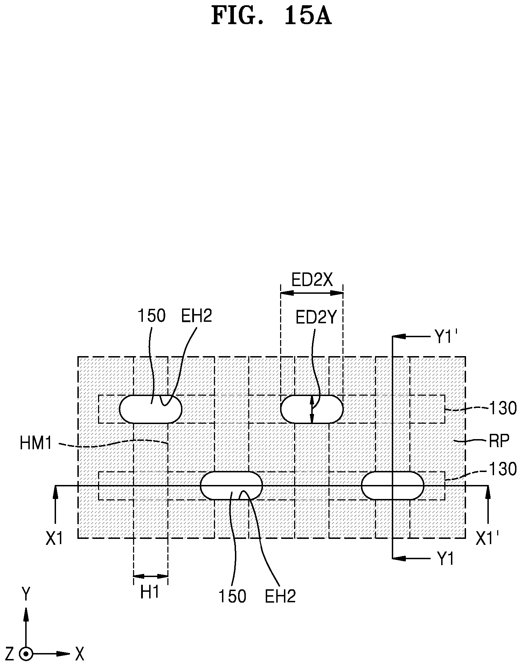

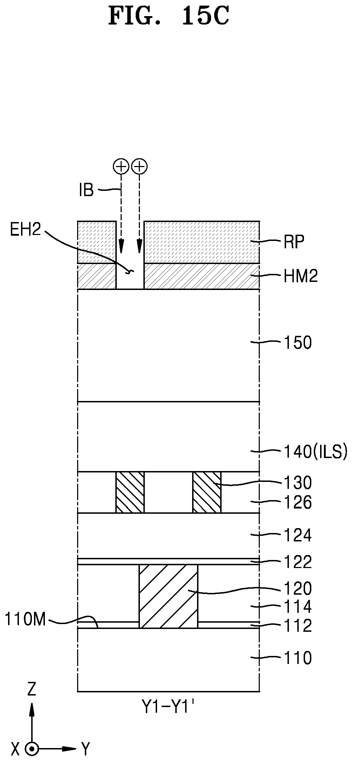

FIGS. 11A to 20C are diagrams of process sequences of methods of manufacturing IC devices, according to an example embodiment. FIGS. 11A, 12A, 13A, 14A, 15A, 16A, 17A, 18A, 19A, and 20A are plan views of process sequences of methods of manufacturing IC devices, according to an example embodiment. FIGS. 11B, 12B, 13B, 14B, 15B, 16B, 17B, 18B, 19B, and 20B are cross-sectional views taken along lines X1-X1' of FIGS. 11A, 12A, 13A, 14A, 15A, 16A, 17A, 18A, 19A, and 20A, respectively. FIGS. 15C, 16C, 17C, 18C, 19C, and 20C are cross-sectional views taken along lines Y1-Y1' of FIGS. 15A, 16A, 17A, 18A, 19A, and 20A, respectively. An example of a method of manufacturing the IC device 100 described with reference to FIGS. 1A, 1B, 1C, and 2 is described with reference to FIGS. 11A to 20C. In FIGS. 11A to 20C, the same reference numerals are used to denote the same elements as in FIGS. 1A, 1B, 1C, and 2, and detailed descriptions thereof are omitted.

Referring to FIGS. 11A and 11B, a first lower etch stop film 112 and a first interlayer insulating film 114 may be formed on a substrate 110, and a conductive structure 120 may be formed to pass through the first interlayer insulating film 114 and the first lower etch stop film 112 and electrically connectable to a conductive region(not shown) of the substrate 110. The formation of the conductive structure 120 may include partially etching the first interlayer insulating film 114 and the first lower etch stop film 112 to form an opening and filling the opening with conductive materials. The conductive structure 120 may be electrically connected to the conductive region formed in the substrate 110. In some other example embodiments, the conductive structure 120 may be a source/drain region of a transistor, a source/drain contact, a via contact, or a gate contact, without being limited thereto.

A second lower etch stop film 122 and a second interlayer insulating film 124 may be formed on the first interlayer insulating film 114. A lower insulating film 126 may be formed on the second interlayer insulating film 124 A plurality of lower metal wiring layers 130 may be formed to pass through the lower insulating film 126 in a vertical direction (Z direction).

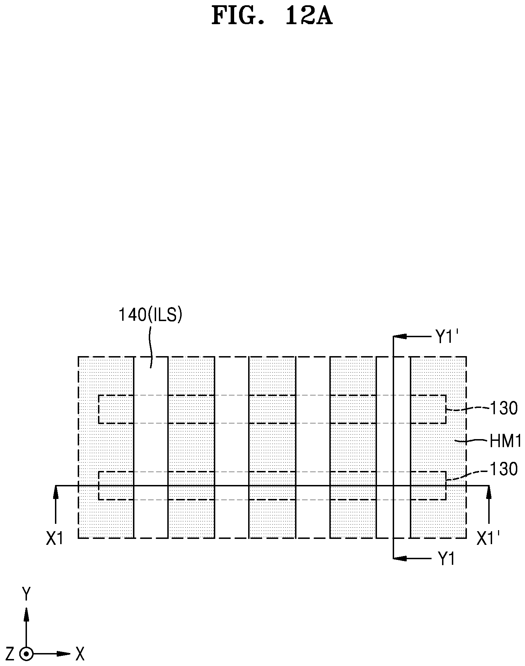

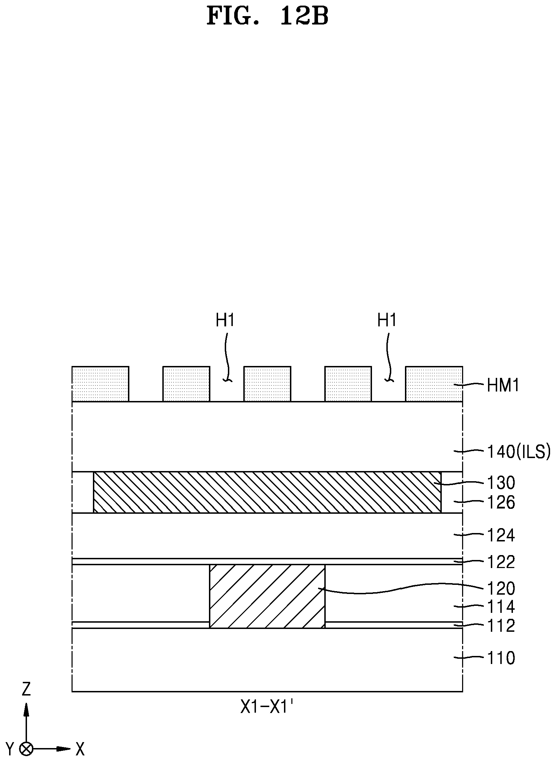

Referring to FIGS. 12A and 12B, an upper insulating film 140 having a planarized top surface may be formed on the lower insulating film 126 and the plurality of lower metal wiring layers 130. Thereafter, a first hard mask pattern HM1 may be formed on the upper insulating film 140. The first hard mask pattern HM1 may include a plurality of first openings H1 having planar shapes corresponding to planar shapes of a plurality of upper metal wiring layers (refer to 180L in FIGS. 1A, 1B, 1C, and 2), respectively. The top surface of the upper insulating film 140 may be exposed through the plurality of first openings H1 formed in the first hard mask pattern HM1. In some example embodiments, the first hard mask pattern HM1 may include a metal-containing mask pattern. For example, the first hard mask pattern HM1 may include a titanium nitride (TiN) film, a tungsten (W) film, a tungsten (W)-doped carbon film, or a combination thereof, without being limited thereto.

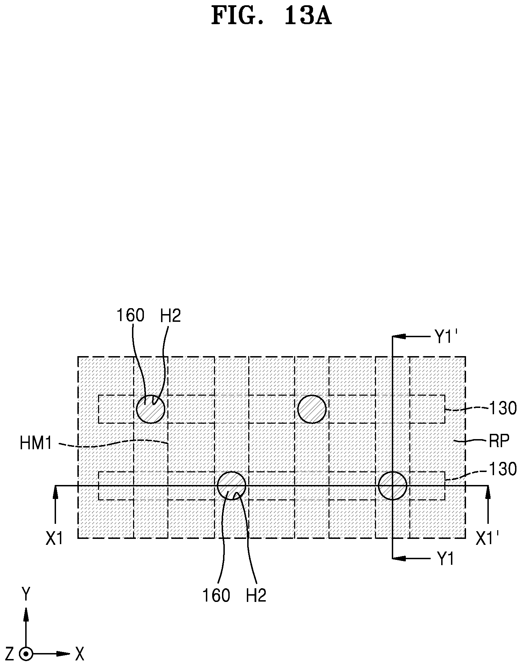

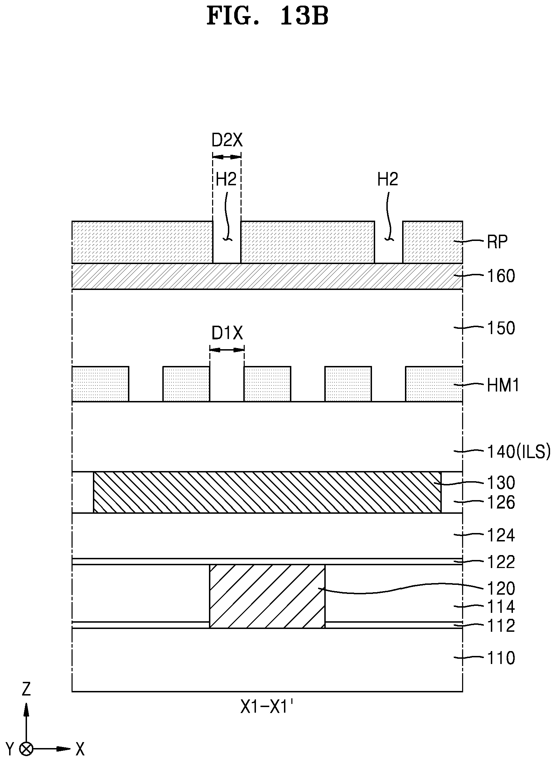

Referring to FIGS. 13A and 13B, a planarized hard mask layer 150 may be formed on the resultant structure of FIGS. 12A and 12B. In some example embodiments, the planarized hard mask layer 150 may include a SOH(spin on hardmask (SOH) film, without being limited thereto.

An inorganic hard mask layer 160 may be formed on the planarized hard mask layer 150. In some example embodiments, the inorganic hard mask layer 160 may include a silicon oxynitride (SiON) film, without being limited thereto.

A photoresist pattern RP may be formed on the inorganic hard mask layer 160. A plurality of second openings H2 may be formed in the photoresist pattern RP. The plurality of second openings H2 may be located on the plurality of lower metal wiring layers 130 to correspond to regions where a plurality of conductive contact plugs 180C are to be formed. That is, the plurality of second openings H2 formed in the photoresist pattern RP may overlap the plurality of first openings H1 formed in the first hard mask pattern HM1 in the vertical direction (Z direction).

In a first lateral direction (X direction), a planar size (X-Y planar size) of each of the plurality of second openings H2 formed in the photoresist pattern RP may be less than a planar size (X-Y planar size) of each of the plurality of conductive contact plugs 180C. The inorganic hard mask layer 160 may be exposed through the plurality of second openings H2. In some example embodiments, the photoresist pattern RP may be formed by exposure to extreme ultraviolet (EUV) light having a wavelength of 13.5 nm, without being limited thereto.

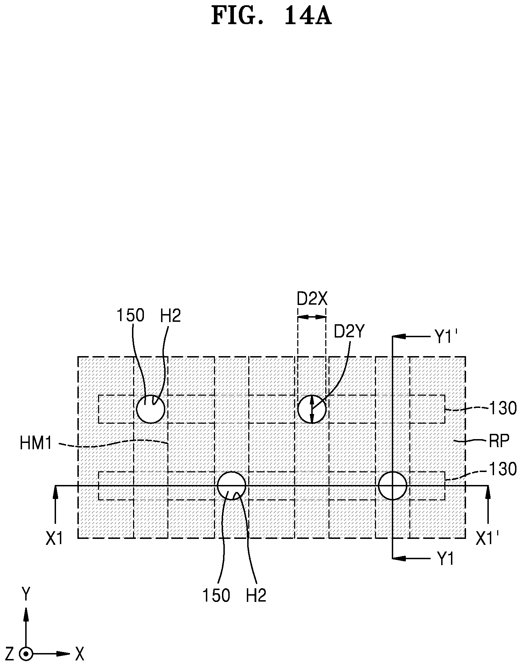

In some example embodiments, in the first lateral direction (X direction), a width D2X of each of the plurality of second openings H2 formed in the photoresist pattern RP may be less than a width D1X of each of the plurality of first openings H1 formed in the first hard mask pattern HM1. In a second lateral direction (Y direction), a width D2Y (see FIG. 14A) of each of the plurality of second openings H2 formed in the photoresist pattern RP may be substantially equal to a width of the lower metal wiring layer 130.

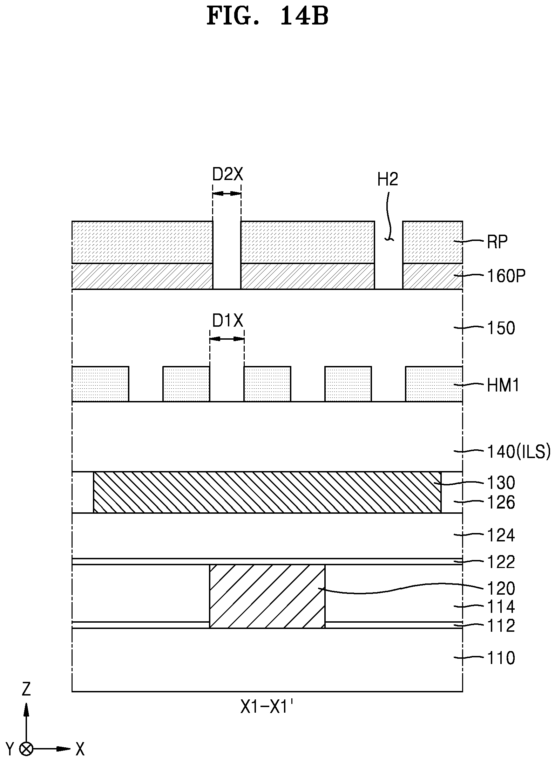

Referring to FIGS. 14A and 14B, in the resultant structure of FIGS. 13A and 13B, the inorganic hard mask layer 160 may be etched by using the photoresist pattern RP as an etch mask to form an inorganic hard mask pattern 160P. Thus, the plurality of second openings H2 may extend to a space passing through the inorganic hard mask pattern 160P in the vertical direction (Z direction), and the planarized hard mask layer 150 may be exposed through the plurality of second openings H2.

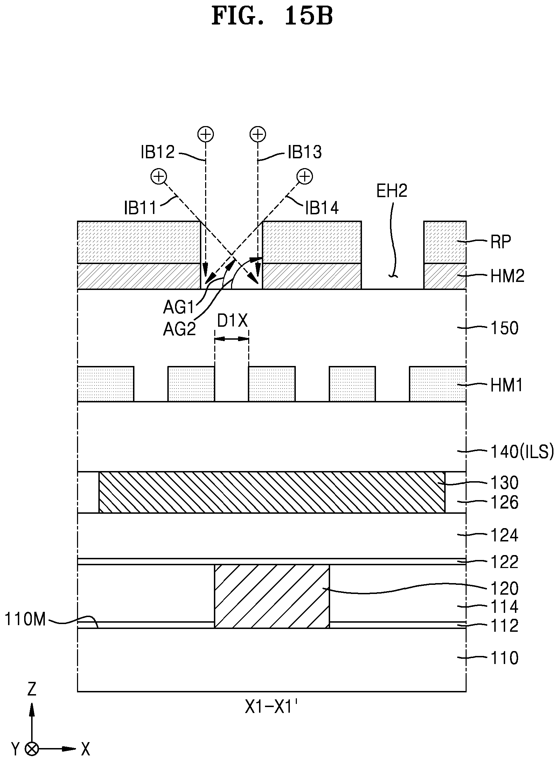

Referring to FIGS. 15A, 15B, and 15C, in the resultant structure of FIGS. 14A and 14B, from among the width D2X of each of the plurality of second openings H2 in the first lateral direction (X direction) and the width D2Y of each of the plurality of second openings H2 in the second lateral direction (Y direction), only the width D2X in the first lateral direction (X direction) may be selectively increased. Thus, a second hard mask pattern HM2 having a plurality of extended second openings EH2 may be obtained from the inorganic hard mask pattern 160P. The plurality of extended second openings EH2 may pass through the photoresist pattern RP and the second hard mask pattern HM2 in a vertical direction.

A width ED2X of each of the plurality of extended second openings EH2 in the first lateral direction (X direction) may be greater than a width D1X of each of the plurality of first openings H1 in the first lateral direction (X direction). A width ED2Y of each of the plurality of extended second openings EH2 in the second lateral direction (Y direction) may be substantially equal to a width D2Y of each of the plurality of first openings H1 in the second lateral direction (Y direction). Of an outline of each of the plurality of extended second openings EH2, portions that intersect the first opening H1 of the first hard mask pattern HM1 in the first lateral direction (X direction) may include straight lines that follow the first lateral direction (X direction).

In some example embodiments, to form the plurality of extended second openings EH2 by selectively increasing the width D2X of each of the plurality of second openings H2 in the first lateral direction (X direction), an etching process in an oblique direction or a tilted direction (hereinafter, a tilting etch process) may be performed. To perform the tilted etch process, an etching process using ion beams (hereinafter, an ion beam etch process) may be performed. In some example embodiments, the ion beam etch process may be an ion beam etch process using a reactive gas (e.g., a fluorine (F)-based gas) as an ion source. During the ion beam etch process, argon (Ar) may be used as the ion source in addition to the fluorine-based gas. Fluorocarbon-based gases, such as CF₄, C₂F₆, C₃F₈, C₄F₆ gas, C₄F₈, may be used as the fluorine-based gas, without being limited thereto.

In some example embodiments, to form the plurality of extended second openings EH2 by selectively increasing the width D2X of each of the plurality of second openings H2 in the first lateral direction (X direction), as shown in FIG. 15B, the ion beam etch process may be performed by varying an ion beam incidence direction in a direction selected within a range between a direction of a dashed arrow IB11 and a direction of a dashed arrow IB13 and a range between a direction of a dashed arrow IB12 and a direction of a dashed arrow IB14 in the first lateral direction (X direction). During the ion beam etch process, a variation range of the ion beam incidence direction in the first lateral direction (X direction) may be selected within a range from a first angle AG1 to a second angle AG2. The first angle may be an angle greater than 45° with respect to a straight line parallel to a main surface 110M of the substrate 110, and the second angle AG2 may be an angle perpendicular to the main surface 110M of the substrate 110. For example, during the ion beam etch process, a variation range of the ion beam incidence direction in the first lateral direction (X direction) may be selected within a range of about 50° to about 90° with respect to a straight line parallel to the main surface 110M of the substrate 110.

Unlike in the first lateral direction (X direction), in the second lateral direction (Y direction), the ion beam etch process may be performed while ion beams are incident in a direction of dashed arrows IB, which is perpendicular to the main surface 110M of the substrate, as illustrated in FIG. 15C.

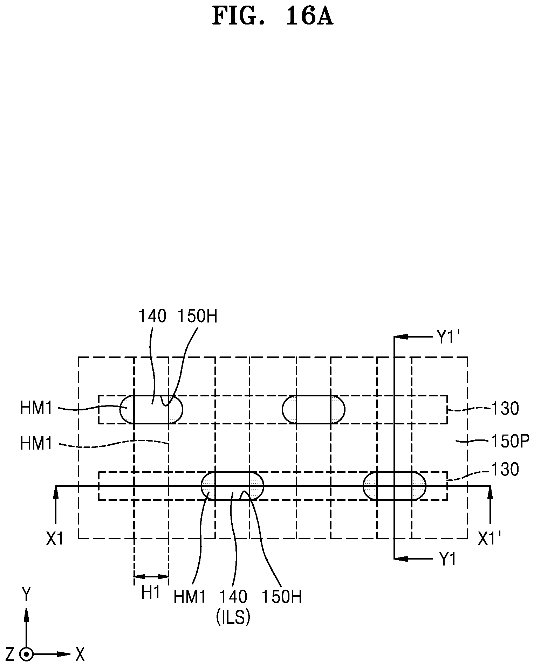

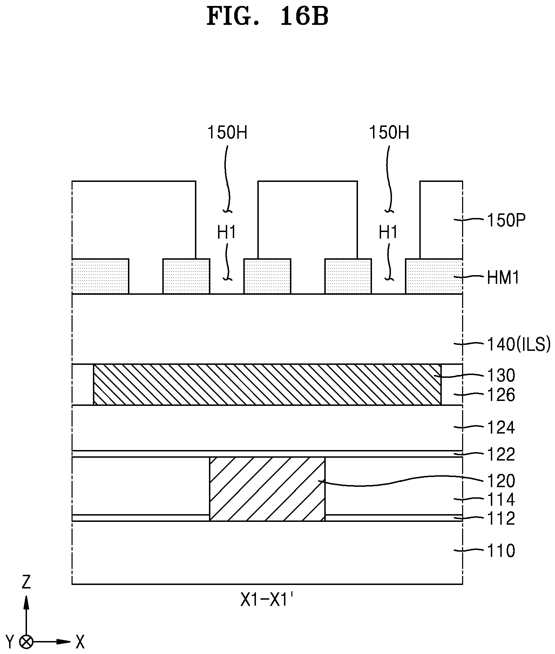

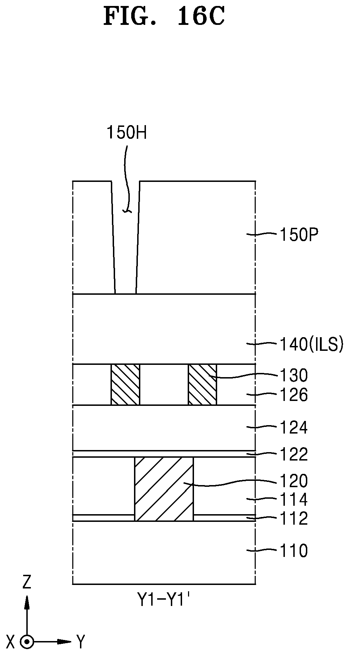

Referring to FIGS. 16A, 16B, and 16C, the planarized hard mask layer 150 may be etched by using the second hard mask pattern HM2 as an etch mask, and thus, a hard mask pattern 150P having a plurality of elliptical holes 150H exposing a portion of the first hard mask pattern HM1 may be formed. As used herein, the hard mask pattern 150P may also be referred to as a third hard mask pattern. Of an outline of each of the plurality of elliptical holes 150H of the hard mask pattern 150P, portions that intersect the first opening H1 of the first hard mask pattern HM1 in the first lateral direction (X direction) may include straight lines that follow the first lateral direction (X direction).

After the hard mask pattern 150P including the plurality of elliptical holes 150H is formed, residues of unnecessary films (e.g., the second hard mask pattern HM2 and the photoresist pattern RP) that remain on the hard mask pattern 150P may be removed. In some example embodiments, the photoresist pattern RP may be removed in advance before an etching process of forming the hard mask pattern 150P is performed.

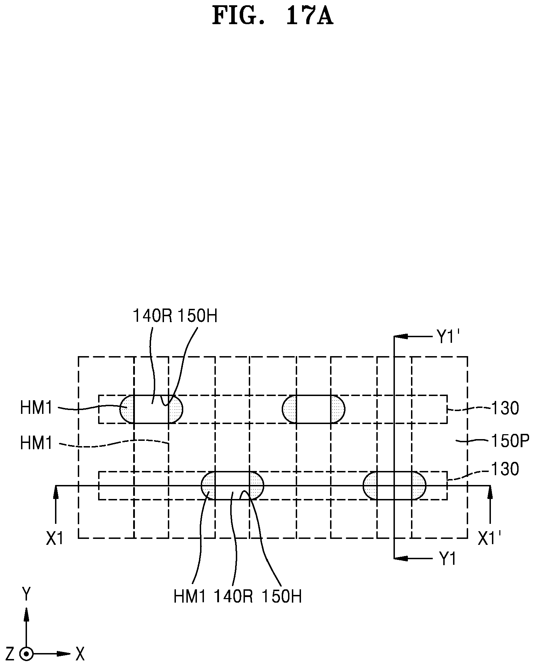

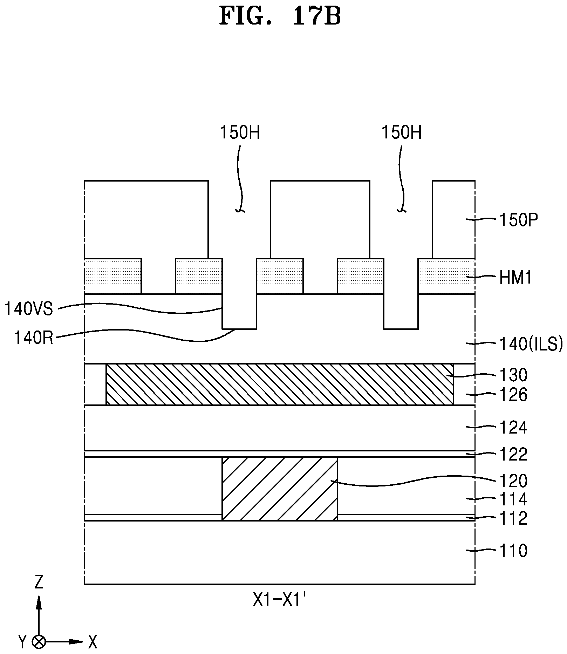

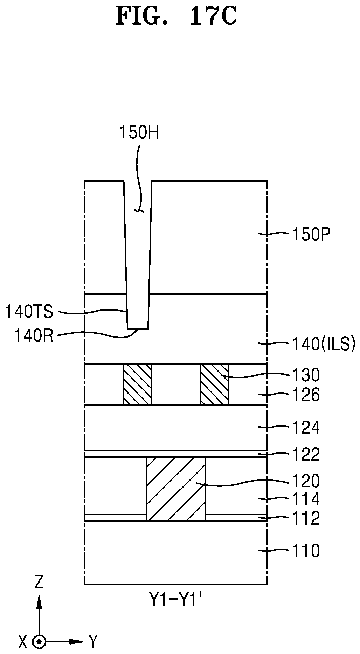

Referring to FIGS. 17A, 17B, and 17C, in the resultant structure of FIGS. 16A, 16B, and 16C, the upper insulating film 140 may be etched by a partial thickness by means of an anisotropic etching process using the hard mask pattern 150P and the first hard mask pattern HM1 as etch masks, and thus, a plurality of recess holes 140R may be formed in partial regions of the upper insulating film 140.

In some example embodiments, the plurality of recess holes 140R may be formed in the upper insulating film 140 by using a plasma-enhanced atomic layer etching (PEALE) process. In some example embodiments, the formation of the plurality of recess holes 140R in the upper insulating film 140 may include supplying an etch gas along with Ar gas onto a surface to be etched in a reaction chamber in which the resultant structure of FIGS. 16A, 16B, and 16C is loaded, purging the inside of the reaction chamber into which the etch gas is supplied by using the Ar gas, supplying a reactive gas along with Ar gas into the reaction chamber, and purging the inside of the reaction chamber into which the reactive gas is supplied. In some example embodiments, the etch gas may include a fluorocarbon compound. For example, the etch gas may include CHF₃, CH₂F₂, CH₃F, CF₄, C₂F₆, C₄F₈, C₄F₆, or a combination thereof, without being limited thereto. The reactive gas may include O₂, CO₂, N₂O, or a combination thereof, without being limited thereto.

During the supplying of the etch gas along with the Ar gas into the reaction chamber, pulsed radio-frequency (RF) power may be applied to the reaction chamber to generate reactive species of the Ar gas and bring a surface of the upper insulating film 140 on which the etch gas is chemisorbed, into contact with the reactive species such that the upper insulating film 140 is etched.

While the upper insulating film 140 is being anisotropically etched to form the plurality of recess holes 140R, when viewed from a cross-section taken in the first lateral direction (X direction) as shown in FIG. 17B, an etch gas for etching the upper insulating film 140 and/or a reactive gas may be supplied through a plurality of elliptical holes 150H having a relatively great width in the first lateral direction (X direction). In this case, a relatively large amount of etch gas and/or reactive gas may reach the upper insulating film 140, which is a film to be etched, through the plurality of elliptical holes 150H having the relatively great width in the first lateral direction (X direction). Thus, in a cross-section taken in the first lateral direction (X direction), the upper insulating film 140 may be etched to have a vertical sidewall 140VS, which is aligned with a sidewall of the first hard mask pattern HM1 and extends in the vertical direction (Z direction). Thus, a width of each of the plurality of recess holes 140R in the first lateral direction (X direction) may be defined by the vertical sidewall 140VS that extends in the vertical direction (Z direction).

In contrast, while the upper insulating film 140 is being anisotropically etched to form the plurality of recess holes 140R, when viewed from a cross-section taken in the second lateral direction (Y direction) as shown in FIG. 17C, an etch gas for etching the upper insulating film 140 and/or a reactive gas may be supplied through a plurality of elliptical holes 150H having a relatively small width in the second lateral direction (Y direction). In this case, a relatively small amount of etch gas and/or reactive gas may reach the upper insulating film 140, which is the film to be etched, through the plurality of elliptical holes 150H having the relatively small width in the second lateral direction (Y direction). As a result, after the plurality of recess holes 140R are formed in the upper insulating film 140, in a cross-section taken in the second lateral direction (Y direction), an inclined sidewall 140TS defining a width of each of the plurality of recess holes 140R in the second lateral direction (Y direction) may be formed in the upper insulating film 140. A width of each of the plurality of recess holes 140R in the second lateral direction (Y direction) may reduce toward the substrate 110.

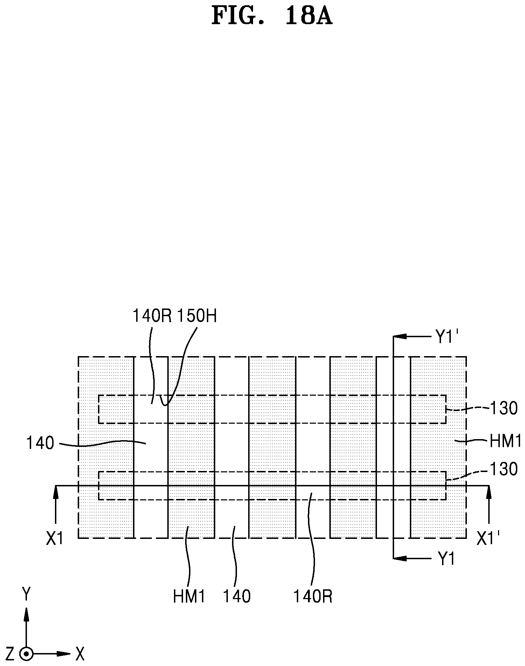

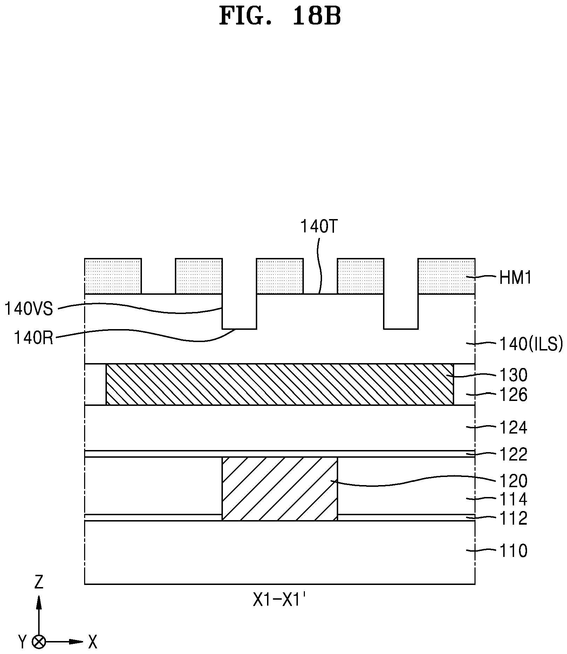

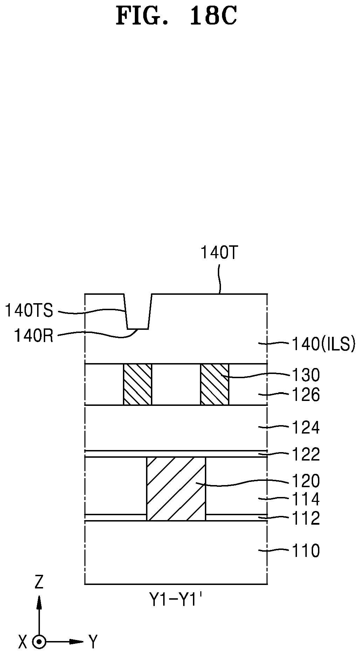

Referring to FIGS. 18A, 18B, and 18C, the hard mask pattern 150P may be removed from the resultant structure of FIGS. 17A, 17B, and 17C to expose a top surface 140T of the upper insulating film 140. When the hard mask pattern 150P includes a spin-on-hardmask (SOH) film, the hard mask pattern 150P may be removed by using an ashing process and a strip process.

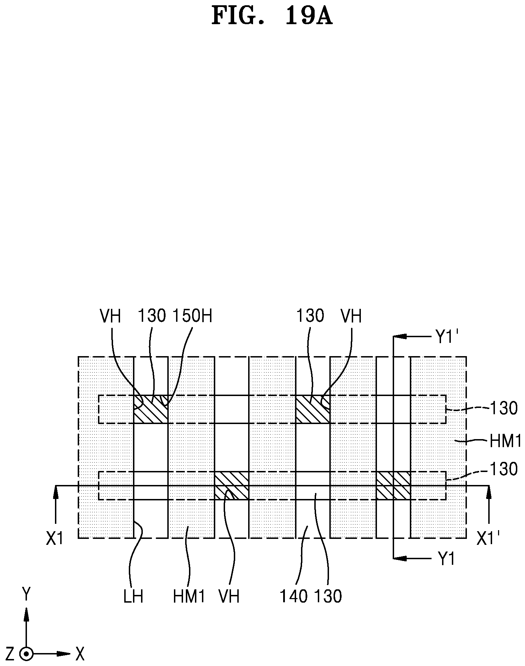

Referring to FIGS. 19A, 19B, and 19C, in the resultant structure of FIGS. 18A, 18B, and 18C, the upper insulating film 140 may be etched by using the first hard mask pattern HM1 as an etch mask, and thus, a plurality of line spaces LH and a plurality of via spaces VH may be formed in the upper insulating film 140. The plurality of line spaces LH may be the resultant structure obtained by etching a portion of the upper insulating film 140 from the top surface 140T of the upper insulating film 140, which is exposed in the resultant structure of FIGS. 18B and 18C. The plurality of line spaces LH may be apart from the plurality of lower metal wiring layers 130 and the lower insulating film 126 in the vertical direction (Z direction). The plurality of via spaces VH may be the resultant structure obtained by etching a portion of the upper insulating film 140 from the plurality of recess holes 140R in the resultant structure of FIGS. 18B and 18C. The lower metal wiring layer 130 may be exposed through each of the plurality of via spaces VH.

Similar to the description provided with reference to FIGS. 18A, 18B, and 18C, the plurality of via spaces VH may be defined by the vertical sidewall 140VS of the upper insulating film 140, which is aligned with the sidewall of the first hard mask pattern HM1 and extends in the vertical direction (Z direction), in the cross-section taken in the first lateral direction (X direction), and may be defined by the inclined sidewall 140TS of the upper insulating film 140 in a cross-section taken in the second lateral direction (Y direction). A width of each of the plurality of via spaces VH in the second lateral direction (Y direction) may reduce toward the substrate 110.

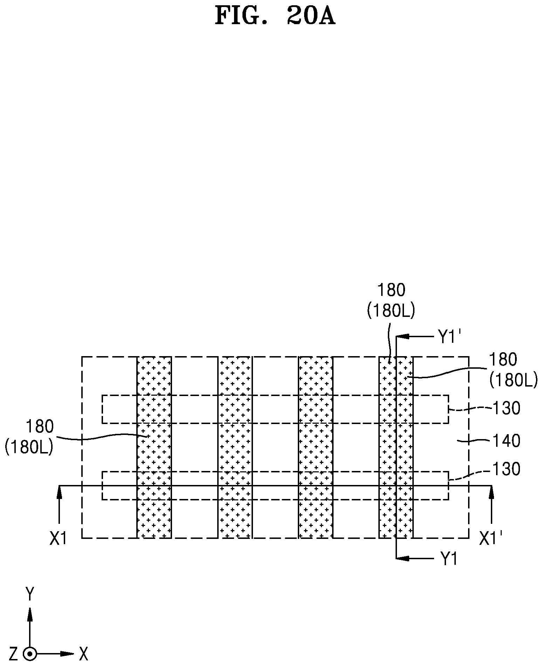

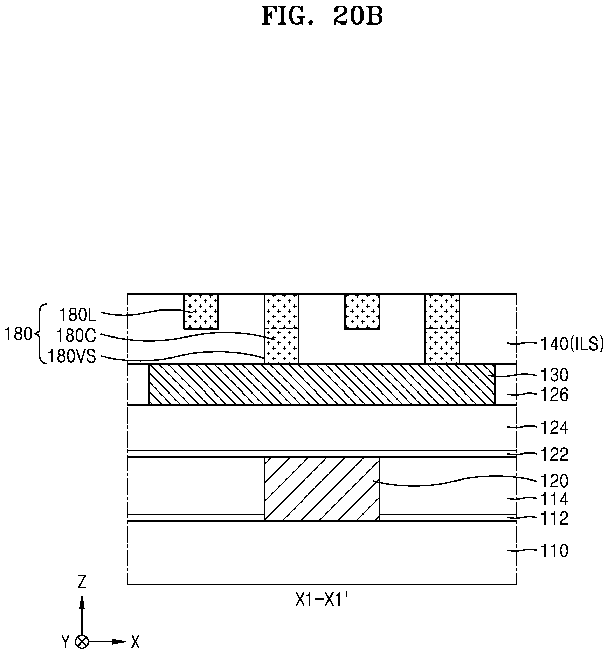

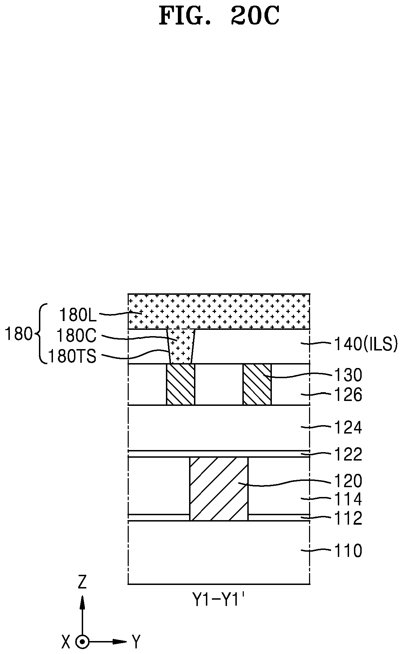

Referring to FIGS. 20A, 20B, and 20C, in the resultant structure of FIGS. 19A, 19B, and 19C, a metal-containing conductive layer may be formed to fill the plurality of via spaces VH and the plurality of line spaces LH. The metal-containing conductive layer may include a metal plug and a conductive barrier film surrounding a sidewall and a bottom surface of the metal plug. The metal plug may include Cu, W, Mo, Ru, Co, Al, or a combination thereof. For example, the metal plug may include Cu. The conductive barrier film may include a TiN film, a TaN film, a Co film, or a combination thereof. For example, when the metal plug includes Cu, the conductive barrier film may include a multilayered structure including a TaN film and a Co film, without being limited thereto.

Thereafter, the metal-containing conductive layer may be planarized such that the top surface of the upper insulating film 140 is exposed, and thus, a plurality of upper metal wiring structures 180 may be formed from the metal-containing conductive layer.

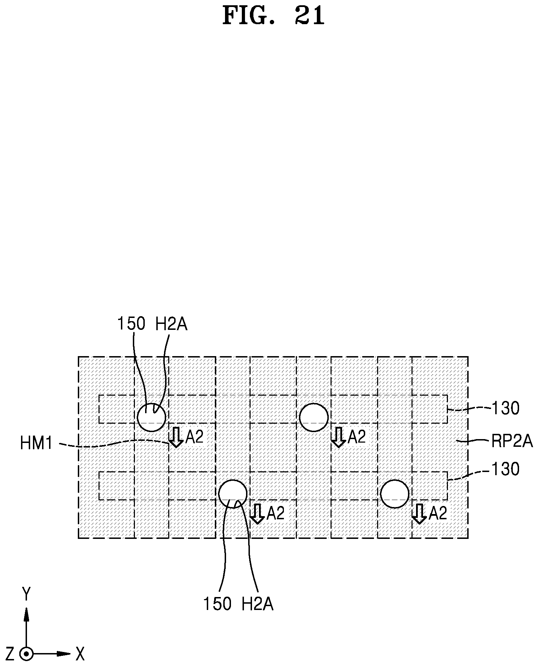

FIG. 21 is a plan view illustrating a method of manufacturing an IC device, according to an example embodiment. An example of a method of manufacturing the IC device 200A shown in FIGS. 3A, 3B, 3C, and 4 is described with reference to FIG. 21. In FIG. 21, the same reference numerals are used to denote the same elements as in FIGS. 1A to 20C, and detailed descriptions thereof are omitted.

Referring to FIG. 21, the processes described with reference to FIGS. 11A to 14B may be performed. However, a photoresist pattern RP2A may be formed instead of the photoresist pattern RP in the process described with reference to FIGS. 13A and 13B. A plurality of second openings H2A may be formed in the photoresist pattern RP2A. The plurality of second openings H2A may be located to correspond to positions of a plurality of conductive contact plugs (refer to 280C in FIGS. 3A, 3B, 3C, and 4), which are to be formed on a plurality of lower metal wiring layers 130. In a first lateral direction (X direction), a planar size (X-Y planar size) of each of the plurality of second openings H2A may be less than a planar size (X-Y planar size) of each of the plurality of conductive contact plugs 280C.

In a view from above (on an X-Y plane), each of the plurality of second openings H2A formed in the photoresist pattern RP2A may be formed at a position shifted by a distance greater than 0 from the pair of lower line sidewalls (refer to 130S in FIGS. 3C and 4) of the lower metal wiring layer 130 corresponding thereto in a direction (e.g., a direction indicated by arrow A2 in FIG. 21) selected from the second lateral direction (Y direction) and a direction opposite to the second lateral direction (Y direction).

Afterwards, according to a process similar to that described with reference to FIGS. 14A and 14B, the inorganic hard mask layer (refer to 160 in FIGS. 13A and 13B) may be etched by using the photoresist pattern RP2A as an etch mask to form an inorganic hard mask pattern 160P. Thus, the plurality of second openings H2A may extend to a space passing through the inorganic hard mask pattern 160P in the vertical direction (Z direction), and the planarized hard mask layer 150 may be exposed through the plurality of second openings H2A. Thereafter, the processes described with reference to FIGS. 15A to 20C may be performed on the resultant structure of FIG. 21, and thus, the IC device 200A described with reference to FIGS. 3A, 3B, 3C, and 4 may be manufactured.

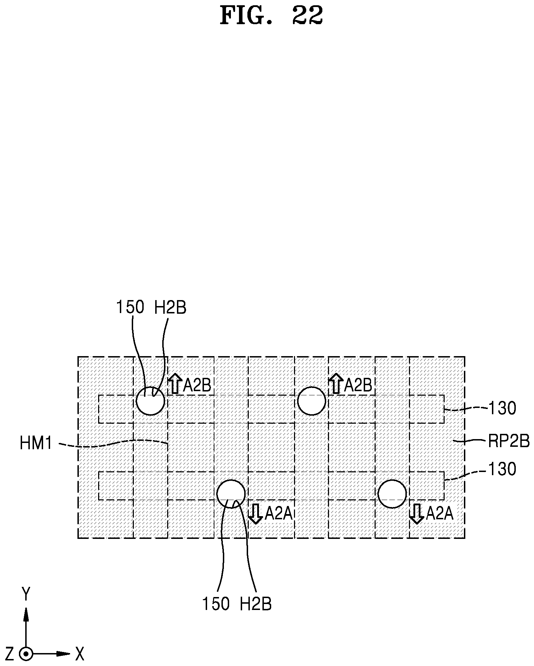

FIG. 22 is a plan view of a method of manufacturing an IC device, according to an example embodiment. An example of a method of manufacturing the IC device shown in FIGS. 5A and 5B is described with reference to FIG. 22. In FIG. 22, the same reference numerals are used to denote the same elements as in FIGS. 1A to 21, and detailed descriptions thereof are omitted.

Referring to FIG. 22, the processes described with reference to FIGS. 11A to 14B may be performed. However, a photoresist pattern RP2B may be formed instead of the photoresist pattern RP in the process described with reference to FIGS. 13A and 13B. A plurality of second openings H2B may be formed in the photoresist pattern RP2B. The plurality of second openings H2BA may be located to correspond to positions of a plurality of first conductive contact plugs (refer to 280C1 in FIGS. 5A and 5B) and a plurality of second conductive contact plugs (refer to 280C2 in FIGS. 5A and 5B), which are to be formed on a plurality of lower metal wiring layer 130. A planar size (X-Y planar size) of each of the plurality of second openings H2B in a first lateral direction (X direction) may be less than a planar size (X-Y planar size) of each of a plurality of first conductive contact plugs 280C1 and a plurality of second conductive contact plugs 280C2.

In a view from above (on an X-Y plane), each of some of the plurality of second openings H2B formed in the photoresist pattern RP2B may be formed at a position shifted by a distance greater than 0 from a pair of lower line sidewalls (refer to 130S in FIG. 5B) of the lower metal wiring layer 130 corresponding thereto in a direction (e.g., a direction indicated by arrow A2A in FIG. 22) opposite to a second lateral direction (Y direction). In a view from above (on an X-Y plane), each of some others of the plurality of second openings H2B formed in the photoresist pattern RP2B may be formed at a position shifted by a distance greater than 0 from the pair of lower line sidewalls (refer to 130S in FIG. 5B) of the lower metal wiring layer 130 corresponding thereto in the second lateral direction (Y direction) (e.g., a direction indicated by arrow A2B in FIG. 22).

Subsequently, according to a process similar to that described with reference to FIGS. 14A and 14B, an inorganic hard mask layer (refer to 160 in FIGS. 13A and 13B) may be etched by using the photoresist pattern RP2B as an etch mask to form an inorganic hard mask pattern 160P. As a result, the plurality of second openings H2B may extend to a space passing through the inorganic hard mask pattern 160P in a vertical direction (Z direction), and the planarized hard mask layer 150 may be exposed through the plurality of second openings H2B. Thereafter, the processes described with reference to FIGS. 15A to 20C may be performed on the resultant structure of FIG. 22, and thus, the IC device 200B described with reference to FIGS. 5A and 5B may be manufactured.

Although the methods of manufacturing the IC devices 100, 200A, and 200B shown in FIGS. 1A to 5B have been described with reference to FIGS. 11A to 22, it will be understood that the IC devices 300, 400, and 500 shown in FIGS. 6A to 10 and IC devices having variously changed structures may be manufactured by applying various modifications and changes to the processes described with reference to FIGS. 11A to 22 within the scope of the inventive concepts.

While the inventive concepts have been particularly shown and described with reference to some example embodiments thereof, it will be understood that various changes in form and details may be made therein without departing from the scope of the following claims.

## Claims

1. An integrated circuit device comprising:
a lower insulating film (126) on a substrate (110);
a first lower metal wiring layer (130A; 130) passing through the lower insulating film (126) and extending lengthwise in a first lateral direction (X);
an upper insulating film (140; 340) on the lower insulating film (126) and the first lower metal wiring layer (130A; 130);
a first upper metal wiring layer (180LA; 280L) extending lengthwise in a second lateral direction (Y) on the upper insulating film (140; 340), wherein the second lateral direction (Y) is perpendicular to the first lateral direction (X); and
a first conductive contact plug (180CA; 180C; 280C; 280C1) passing through the upper insulating film (140; 340) in a vertical direction (Z), the first conductive contact plug (180CA; 180C; 280C; 280C1) contacting each of the first lower metal wiring layer (130A; 130) and the first upper metal wiring layer (180LA; 280L),
wherein the first conductive contact plug (180CA; 180C; 280C; 280C1) has a tetragonal shape in a view from above,
the first conductive contact plug (180CA; 180C; 280C; 280C1) comprises a first pair of first contact sidewalls (180VS; 280VS), which are opposite to each other in the first lateral direction (X), and a first pair of second contact sidewalls (180TS; 280TS), which are opposite to each other in the second lateral direction (Y),
each of the first pair of first contact sidewalls (180VS; 280VS) extends in the vertical direction (Z) from a corresponding one of a first pair of upper line sidewalls (180LS; 280LS) of the first upper metal wiring layer (180LA; 280L) to the first lower metal wiring layer (130A; 130), and
at least one of the first pair of second contact sidewalls (180TS; 280TS) extends in a direction inclined with respect to the vertical direction (Z) from a bottom surface of the first upper metal wiring layer (180LA; 280L) toward the first lower metal wiring layer (130A; 130).

2. The integrated circuit device of claim 1, wherein
the first upper metal wiring layer (180LA; 280L) and the first conductive contact plug (180CA; 180C; 280C; 280C1) have a same width in the first lateral direction (X),
a width of each of the first upper metal wiring layer (180LA; 280L) and the first conductive contact plug (180CA; 180C; 280C; 280C1) in the first lateral direction (X) is constant in the vertical direction (Z), and
a width of the first conductive contact plug (180CA; 180C; 280C; 280C1) in the second lateral direction (Y) gradually reduces toward the first lower metal wiring layer (130A; 130).

3. The integrated circuit device of claim 1 or 2, wherein, in a view from above,
each of the first pair of first contact sidewalls (180VS) of the first conductive contact plug (180CA; 180C) extends along an extension line (LU) of a first straight line, along which the upper line sidewall (180LS) of the first upper metal wiring layer (180LA) in the second lateral direction (Y) extends, and
each of the first pair of second contact sidewalls (180TS) of the first conductive contact plug (180CA) extends along an extension line (LL) of a second straight line, along which a lower line sidewall (130S) of the first lower metal wiring layer (130A; 130) in the first lateral direction (Y) extends.

4. The integrated circuit device of claim 1 or 2, wherein the first conductive contact plug (280C; 280C1) comprises a main contact portion (280M) covering a top surface of the first lower metal wiring layer (130) and a protruding contact portion (280P) covering a sidewall (130S) of the first lower metal wiring layer (130), the protruding contact portion (280P) being between the first lower metal wiring layer (130) and the lower insulating film (126).

5. The integrated circuit device of claim 1, 2 or 4, wherein, in a view from above,
each of the first pair of first contact sidewalls (280VS) of the first conductive contact plug (280C; 280C1) extends in an extension line (LL2; LL2A) of a first straight line, along which the upper line sidewall (280LS) of the first upper metal wiring layer (280L) in the second lateral direction (Y) extends, and
each of the first pair of second contact sidewalls (280TS) of the first conductive contact plug (280C; 280C1) extends in an extension line (LU2; LU2A) of a second straight line, which extends in the first lateral direction (X), at a position shifted, in a selected one of the second lateral direction (Y) and a direction opposite to the second lateral direction (Y), by a first distance greater than 0 from a lower line sidewall (130S) of the first lower metal wiring layer (130A), the lower line sidewall (130S) of the first lower metal wiring layer (130A) extending in the first lateral direction (X).

6. The integrated circuit device of any one of claims 1 to 5, wherein the first conductive contact plug (180CA; 280C; 280C1) is integrally connected to the first upper metal wiring layer (180LA; 280L).

7. The integrated circuit device of any one of claims 1 to 6, further comprising:
an etch stop film (332) between the lower insulating film (126) and the upper insulating film (340),
wherein a portion of the first conductive contact plug (180C) passes through the etch stop film (332).

8. The integrated circuit device of any one of claims 1 to 7, wherein, in a view from above, a planar shape of the first conductive contact plug (180CA; 180C; 280C; 280C1) is the same as a planar shape of a region where the first lower metal wiring layer (130A; 130) overlaps the first upper metal wiring layer (180LA; 280L) in the vertical direction (Z).

9. The integrated circuit device of claim 1, further comprising:
a second lower metal wiring layer (130B) passing through the lower insulating film (126) and extending lengthwise in the first lateral direction (X), the first lower metal wiring layer (130A) and the second lower metal wiring layer (130B) being apart from each other in the second lateral direction (Y),
a second upper metal wiring layer (180LB) extending lengthwise in the second lateral direction (Y) on the upper insulating film (140), the first upper metal wiring layer (180LA; 280L) and the second upper metal wiring layer (180LB) overlapping the first lower metal wiring layer (130A) and the second lower metal wiring layer (130B) in a vertical direction (Z), and the first upper metal wiring layer (180LA; 280L) and the second upper metal wiring layer (180LB) being apart from each other in the first lateral direction (X); and
a second conductive contact plug (180CB; 280C2) passing through the upper insulating film (140) in the vertical direction (Z), the second conductive contact plug (180CB; 280C2) contacting each of the second lower metal wiring layer (130B) and the second upper metal wiring layer (180LB),
wherein the upper insulating film (140; 340) is on each of the lower insulating film (126), the first lower metal wiring layer (130A), and the second lower metal wiring layer (130B),
wherein the second conductive contact plug (180CB; 280C2) has a tetragonal shape in a view from above,
wherein the second conductive contact plug (180CB; 280C2) comprises a second pair of first contact sidewalls (180VS; 280VS) and a second pair of second contact sidewalls (180TS; 280TS), the second pair of first contact sidewalls (180VS; 280VS) being opposite to each other in the first lateral direction (X), the second pair of second contact sidewalls (180TS; 280TS) being opposite to each other in the second lateral direction (Y),
wherein each of the second pair of first contact sidewalls (180VS; 280VS) extends in the vertical direction (Z) from a corresponding one of a second pair of upper line sidewalls of the second upper metal wiring layer (180LB) to the second lower metal wiring layer (130B), and
wherein at least one of the second pair of second contact sidewalls (180TS; 280TS) extends in a direction inclined with respect to the vertical direction (Z) from a bottom surface of the second upper metal wiring layer (180LB) toward the second lower metal wiring layer (130B).

10. The integrated circuit device of claim 9, wherein
a width of each of the first conductive contact plug (180CA; 180C; 280C; 280C1) and the second conductive contact plug (180CB; 280C2) in the first lateral direction (X) is constant in the vertical direction (Z), and
a width of each of the first conductive contact plug (180CA; 180C; 280C; 280C1) and the second conductive contact plug (180CB; 280C2) in the second lateral direction (Y) gradually decreases toward the substrate (110).

11. The integrated circuit device of claim 9 or 10, wherein, in a view from above, in each of the first conductive contact plug (180CA; 180C; 280C; 280C1) and the second conductive contact plug (180CB; 280C2),
each first contact sidewall (180VS; 280VS) extends along an extension line of a first straight line, along which a corresponding one of the upper line sidewalls of a corresponding one of the first and second upper metal wiring layers (180LA, 180LB) extends, and,
each second contact sidewall (180TS; 280TS) extends along an extension line of a second straight line, along which a corresponding one of lower line sidewalls of a corresponding one of the first and second lower metal wiring layers (130A, 130B) extends.

12. The integrated circuit device of any one of claims 9 to 11, wherein at least one of the first conductive contact plug (180CA; 180C; 280C; 280C1) and the second conductive contact plug (180CB; 280C2) covers a top surface and a sidewall of a corresponding one of the first and second lower metal wiring layers (130A, 130B).

13. The integrated circuit device of claim 9 or 10, wherein, in a view from above, in each of the first conductive contact plug (180CA; 180C; 280C; 280C1) and the second conductive contact plug (180CB; 280C2),
each first contact sidewall (180VS; 280VS)extends along an extension line of a first straight line, along which a corresponding one of the upper line sidewalls of a corresponding one of the first and second upper metal wiring layers (180LA, 180LB) extends, and
each second contact sidewall (180TS; 280TS) extends in an extension line of a second straight line, which extends in the first lateral direction (X), at a position shifted, in a direction selected from the second lateral direction (Y) and a direction opposite to the second lateral direction (Y), by a first distance greater than 0 from a lower line sidewall of a corresponding one of the first and second lower metal wiring layers (130A, 130B), the lower line sidewall of a corresponding one of the first and second lower metal wiring layers (130A, 130B) extending in the first lateral direction (X).

14. The integrated circuit device of claim 9 or 10, wherein, in a view from above:
in each of the first conductive contact plug (180CA; 180C; 280C; 280C1) and the second conductive contact plug (180CB; 280C2), each first contact sidewall (180VS; 280VS) extends along an extension line of a first straight line, along which a corresponding one of the upper line sidewalls of the corresponding one of the first and second upper metal wiring layers passes,
each of the first pair of second contact sidewalls (180TS; 280TS) of the first conductive contact plug (180CA; 180C; 280C; 280C1) extends along an extension line of a second straight line, which extends in the first lateral direction (X), at a position shifted, in a direction opposite to the second lateral direction (Y), by a first distance greater than 0 from a corresponding one of first lower line sidewalls of the first lower metal wiring layer (130A), and
each of the second pair of second contact sidewalls (180TS; 280TS) of the second conductive contact plug (180CB; 280C2) extends along an extension line of a third straight line, which extends in the first lateral direction (X), at a position shifted, in the second lateral direction (Y), by a second distance greater than 0 from a corresponding one of second lower line sidewalls of the second lower metal wiring layer (130B).

15. The integrated circuit device of any one of claims 9 to 14, wherein, in a view from above,
a planar shape of the first conductive contact plug (180CA; 180C; 280C; 280C1) is a same as a planar shape of a region where the first lower metal wiring layer (130A) overlaps the first upper metal wiring layer (180LA; 280L) in the vertical direction (Z), and
a planar shape of the second conductive contact plug (180CB; 280C2) is same as a planar shape of a region where the second lower metal wiring layer (130B) overlaps the second upper metal wiring layer in the vertical direction (Z).
